# EUROPEAN PATENT APPLICATION

(11) **EP 0 716 454 A2**
(43) Date of publication of application: **12.06.1996**
(21) Application number: 95118578.4
(22) Date of filing: 24.11.1995
(51) Int. Cl.: H01L 29/10, H01L 29/78, H01L 27/092

(54) **MOSFET device formed in epitaxial layer**

(30) Priority: 07.12.1994 JP 304018/94; 07.04.1995 JP 82315/95
(71) Applicant: HITACHI, LTD., Chiyoda-ku, Tokyo 101 (JP)
(72) Inventor: Suzuki, Norio, Tokyo (JP); Kiyota, Shogo, Tokyo (JP); Kubo, Masahuro, Tokyo (JP); Okuyama, Kousuke, Kawagoe-shi, Saitama (JP); Shirasu, Tatsumi, Plano, Texas 75075 (US)
(74) Representative: Strehl Schübel-Hopf Groening & Partner

(57) **Abstract**

Over a well region 3a, 3b formed over a semiconductor substrate body, there is formed an epitaxial layer 2E which has a lower impurity concentration than the well region. MOSFETs are mounted on the epitaxial layer.

A field insulating film 4 is extended in a depth-wise direction to contact with the well region. The MOSFETs have their source/drain regions formed in the epitaxial layer to form a punch-through stopper layer 5N3, 5P3 between the sources and drains.

## Description

### SPECIFICATION

The present application relates to U.S. Serial No.08/508,483 , as filed before U.S. Patent Office on July 28, 1995.

### BACKGROUND OF THE INVENTION

The present invention relates to a semiconductor integrated circuit device and a technique for manufacturing the same. More particularly, the present invention relates to a semiconductor integrated circuit device having an epitaxial layer formed over the surface of a semiconductor substrate body and a technique effective if applied to a processor for manufacturing the same.

There has been progressed a technique for manufacturing a semiconductor integrated circuit device in which an epitaxial layer (a semiconductor single crystal layer) is formed over a mirror-finished semiconductor substrate body and is formed with a predetermined semiconductor integrated circuit element.

This is because the formation of the epitaxial layer provides the excellent effects: the soft-error resistance and the latch-up resistance are improved; and the gate insulating film to be formed over the epitaxial layer can have its breakdown characteristics improved to reduce its defect density drastically.

The semiconductor integrated circuit device having such epitaxial layer is disclosed, for example, on pp. 761 to 763 of "Applied Physics, Vol. 60, Edit. 8" of Association of Applied Physics, issued on August 10, 1991.

This publication describes a semiconductor integrated circuit device constructed such that there is formed over a p⁺(or n⁺)-type semiconductor substrate a p(or n)-type epitaxial layer which contains a p(or n)-type impurity in a lower concentration than that of the p(or n)-type impurity of the semiconductor substrate and which is formed therein with a semiconductor region called the well and equipped thereon with a MOS·FET (Metal Oxide Semiconductor · Field Effect Transistor) or the like.

Incidentally, the well of this case is formed by the impurity diffusion from the surface of the epitaxial layer so that its impurity concentration has higher surface and lower internal distributions.

Another publication is exemplified by Japanese Patent Laid-Open No. 260832/1989 disclosing a construction which is made such that a p-type epitaxial layer is formed over a p-type semiconductor substrate and such that a well is formed to extend from the surface of the epitaxial layer to the upper portion of the semiconductor substrate.

This publication further discloses a process for forming the well by introducing a well forming impurity into the semiconductor substrate body and subsequently by growing the epitaxial layer over the semiconductor substrate body while diffusing the well forming impurity in the upper portion of the semiconductor substrate body.

Incidentally, the impurity concentration of this case is distributed to form a mountainous curve having its peak in the boundary between the epitaxial layer and the semiconductor substrate body, that is, the impurity concentration is low at the surface side of the epitaxial layer, high in the boundary between the epitaxial layer and the semiconductor substrate body, and low in the semiconductor substrate body.

### SUMMARY OF THE INVENTION

However, we have found out that the technique described above has the following problems.

A first problem is that the element is liable to have characteristic fluctuations. Since the element is formed in the well, according to the aforementioned technique, the impurity in the well will fluctuate the element characteristics such as the threshold voltage or the substrate effect.

A second problem is that the well has to set its impurity concentration severely strictly for suppressing its characteristic fluctuations so that its formation is difficult to control.

A third problem is that it is difficult to design the circuit of the semiconductor integrated circuit device. Specifically, since the element is formed in the well, according to that technique, the fluctuations of the threshold voltage and the substrate effect constant are increased in the MOS·FET, for example, to make it difficult to design the circuit of the semiconductor integrated circuit device.

A fourth problem is an obstruction to the improvement in the high-speed action of the semiconductor integrated circuit device. Specifically, the junction capacity in the wiring line of the diffusion layer or the drain portion of the MOS·FET increases to a load capacity.

This problem grows the more serious for the finer structure of the element. Specifically, if the device has its physical size reduced according to a constant coefficient K (K < 1), the impurity concentration in the channel will rise K times to invite a reduction in the carrier mobility due to the impurity scattering and an increase in the junction capacity per unit area of the semiconductor region for the source/drain over the semiconductor substrate.

A fifth problem is that a thermal treatment at a high temperature and for a long time period is required for forming the well. Specifically, in order to raise the breakdown voltage (or punch-through voltage) against the current to flow from the drain of the MOS·FET to the semiconductor substrate, for example, it is necessary to increase the impurity concentration of the well or to deepen the well. What is adopted is to deepen the well because the impurity concentration of the well cannot be made so high from the standpoint of the aforementioned element characteristics. Thus, the thermal treatment at a high temperature and for a long time is required for forming the well.

An object of the present invention is to provide a technique capable of improving the setting accuracy of element characteristics.

An object of the present invention is to provide a technique capable of facilitating the control of well formation.

An object of the present invention is to provide a technique capable of facilitating the circuit design of the semiconductor integrated circuit device.

An object of the present invention is to provide a technique capable of improving the action speed of the semiconductor integrated circuit device.

An object of the present invention is to provide a technique capable of shortening the time period for forming the well.

An object of the present invention is to provide a technique capable of forming an epitaxial layer having an excellent crystallizability.

An object of the present invention is to provide a technique capable of improving the setting accuracy of the impurity concentration in the epitaxial layer.

The foregoing and other objects and the novel features of the present invention will become apparent from the following description to be made with reference to the accompanying drawings.

The representative ones of the invention to be disclosed herein will be briefly summarized in the following.

Specifically, according to the present invention, there is provided a semiconductor integrated circuit device which is characterized: in that a first region containing a first impurity of a predetermined conduction type for forming a PN junction is formed over the principal plane of a semiconductor substrate body; in that an epitaxial layer containing an impurity in a lower concentration than that of first region is formed over the semiconductor substrate body; and in that an element isolating portion is formed in the epitaxial layer within an element isolating region over the semiconductor substrate having the bottom portion at which the PN junction terminates.

In the semiconductor integrated circuit device of the present invention, moreover, the element isolating portion is formed by a channel extending to the upper portion of the semiconductor substrate body.

In the semiconductor integrated circuit device of the present invention, moreover, an insulating film is formed on the surface of the channel by a thermal oxidation method.

In the semiconductor integrated circuit device of the present invention, moreover, a MIS (Metal Insulator Semiconductor) · FET is formed in the epitaxial layer, and an eighth region for a punch-through stopper, which is doped with an impurity having the same conduction type as that of the impurity of the epitaxial layer and a higher impurity concentration than that of the same impurity, is formed at a predetermined depth position in the epitaxial layer.

In the semiconductor integrated circuit device of the present invention, moreover, of the epitaxial layer, the epitaxial layer in an element forming region for an electrostatic protection circuit to be attached to an input circuit constituting an semiconductor integrated circuit and a power circuit has its impurity concentration set equal to or higher than that of the first region.

In the semiconductor integrated circuit device of the present invention, moreover, of the epitaxial layer, the epitaxial layer in a memory cell forming region has its impurity concentration set higher than that of the epitaxial layer in an element forming region for an internal circuit.

In the semiconductor integrated circuit device of the present invention, moreover, of the epitaxial layer, the epitaxial layer in a memory cell forming region has its impurity concentration set, below the semiconductor region other than that to be connected with a data line, to a value higher than that of the epitaxial layer in the element forming region for an internal circuit.

On the other hand, a process for manufacturing a semiconductor integrated circuit device according to the present invention, comprises the following steps (a) to (e):
(a) the step of doping a semiconductor substrate body with the first impurity before the epitaxial layer is formed;
(b) the step of doping the semiconductor substrate body with the second impurity before the epitaxial layer is formed;
(c) the step of forming the epitaxial layer over the principal plane of the semiconductor substrate body doped with the first impurity and the second impurity;
(d) the step of a cap film over the surface of the epitaxial layer; and
(e) the step of forming the first region and the second region by subjecting the semiconductor substrate body formed with the cap film to a thermal diffusion treatment.

Moreover, a process for manufacturing a semiconductor integrated circuit device according to the present invention, comprises the following steps (a') to (f'):
(a') the step of doping a semiconductor substrate body with the first impurity before the epitaxial layer is formed;
(b') the step of doping the semiconductor substrate body with the second impurity before the epitaxial layer is formed;
(c') the step of subjecting the semiconductor substrate body to a thermal treatment for recovering a damage after the steps of introducing the first impurity and the second impurity and before the step of forming the epitaxial layer;
(d') the step of forming the epitaxial layer over the principal plane of the semiconductor substrate body thermally treated for the damage recovery;
(e') the step of forming a cap film over the surface of the epitaxial layer; and
(f') the step of forming the first region and the second region by subjecting the semiconductor substrate body formed with the epitaxial layer to a thermal diffusion treatment.

According to the semiconductor integrated circuit device of the present invention described above, the gate insulating film of the MOS·FET is formed over the epitaxial layer of a semiconductor single crystalline layer so that it can have an excellent film quality to improve its breakdown voltage. At the same time, the lightly doped epitaxial layer, as formed over the heavily doped first and second regions, is formed with the predetermined elements. As a result, the elements can have their characteristics set accurately without being influenced by the impurities in the first region, the second region and the semiconductor substrate body so that the setting accuracy of the element characteristics can be improved.

According to the semiconductor integrated circuit device of the present invention, moreover, the predetermined elements (e.g., MOS·FETs) are formed in the lightly doped epitaxial layer so that the breakdown voltage of the gate insulating film can be improved and so that the junction capacity of the semiconductor regions forming the predetermined elements can be reduced. Thus, it is possible to improve the action speed of the semiconductor integrated circuit device.

According to the semiconductor integrated circuit device of the present invention, moreover, the lightly doped epitaxial layer, as formed over the heavily doped first and second regions, is formed with the predetermined elements. As a result, the breakdown voltage of the gate insulating film can be improved, and the first region and the second region can have their impurity concentrations set substantially independently of the characteristics of the predetermined elements.

According to the semiconductor integrated circuit device of the present invention, moreover, the lightly doped epitaxial layer, as formed over the heavily doped first and second regions, is formed with the predetermined elements. As a result, the breakdown voltage of the gate insulating film can be improved, and the first region and the second region can have their impurity concentrations set substantially independently of the characteristics of the predetermined elements. Thus, it is possible to facilitate the control of forming the first region and the second region.

According to the semiconductor integrated circuit device of the present invention, moreover, the element isolating portion is formed into the channel shape. As a result, even if the epitaxial layer is considerably thick, the element isolating portion capable of isolating the epitaxial layer individually for the element forming regions can be formed without increasing the area occupied by the element isolating portion.

According to the semiconductor integrated circuit device of the present invention, moreover, the insulating film is formed by the thermal oxidation method on the surface of the channel for the element isolating portion. As a result, it is possible to satisfactorily protect the epitaxial layer in the channel, the semiconductor substrate body, and the junction portion of the first and second region.

According to the semiconductor integrated circuit device of the present invention, moreover, it is possible to improve the breakdown voltage of the gate insulating film and the carrier mobility. Moreover, the epitaxial layer, as equipped with the MIS·FETs, is formed at a predetermined depth with the eighth region for the punch-through stopper. As a result, it is possible to prevent the punch-through phenomenon between the sources and drains of the MIS·FETs. On the other hand, the depletion layer depthwise extending from the source/drain can have its extension suppressed in the first region or the second region to prevent the punch-through between the source and the drain.

According to the semiconductor integrated circuit device of the present invention, moreover, the epitaxial layer in the element forming region for the electrostatic protection circuit attached to the input circuit and the power supply has its impurity concentration set equal to or higher than that of the first region. As a result, it is possible to eliminate the deviation of the minority carriers of the base region at the operating time of the bipolar transistors for the electrostatic protection circuit and to prevent any local current concentration in that epitaxial layer. As a result, the current can be uniformly established in the collector/base junctions of the bipolar transistors thereby to prevent the reduction of the electrostatic breakdown voltage of the electrostatic protection circuit.

According to the semiconductor integrated circuit device of the present invention, moreover, of the epitaxial layer, the epitaxial layer in the region forming the memory cells has its impurity concentration set to a value higher than that of the epitaxial layer in the element forming region for the internal circuit. As a result, it is possible to increase the junction capacity of the epitaxial layer and to form the barrier layer for preventing the carriers, which are produced due to the electron-hole pairs by the alpha ray, from invading the information holding portion. As a result, it is possible to prevent the drop of the memory holding characteristics of the semiconductor integrated circuit device having the memory cells.

According to the semiconductor integrated circuit device of the present invention, moreover, of the epitaxial layer, the epitaxial layer in the memory cell forming region has its impurity concentration set, only below the semiconductor region other than that to be connected with the data lines, to a value higher than that of the epitaxial layer in the element forming region for the internal circuit. As a result, it is possible to prevent the drop of the memory holding characteristics without increasing the load capacity of the data line.

According to the semiconductor integrated circuit device of the present invention, moreover, the thermal treatment is done for recovering the damage after the impurity introducing step, followed by forming the epitaxial layer, so that the crystal defect of the semiconductor substrate body surface layer can be reduced to recover the damage. As a result, it is possible to form the epitaxial layer having an excellent crystallizability.

According to the semiconductor integrated circuit device of the present invention, prior to the thermal diffusion treating step for forming the first region and the second region, the cap film is formed over the epitaxial layer so that the first impurity and the second impurity can be suppressed from diffusing into the diffusion furnace during the diffusion treating step while preventing the epitaxial layer from being doped with the impurities having diffused. Thus, it is possible to improve the accuracy of setting the impurity concentration in the epitaxial layer.

### BRIEF DESCRIPTION OF THE DRAWINGS

Fig. 1 is a section showing an essential portion of a semiconductor integrated circuit device according to one embodiment of the present invention;
Fig. 2 is a circuit diagram showing an example of application of the semiconductor integrated circuit device of Fig. 1;
Fig. 3 is a section showing an essential portion of the semiconductor integrated circuit device of Fig. 1 at a manufacture step;
Fig. 4 is a section showing an essential portion of the semiconductor integrated circuit device of Fig. 1 at a manufacture step subsequent to that of Fig. 3;
Fig. 5 is a section showing an essential portion of the semiconductor integrated circuit device of Fig. 1 at a manufacture step subsequent to that of Fig. 4;
Fig. 6 is a section showing an essential portion of the semiconductor integrated circuit device of Fig. 1 at a manufacture step subsequent to that of Fig. 5;
Fig. 7 is a section showing an essential portion of the semiconductor integrated circuit device of Fig. 1 at a manufacture step subsequent to that of Fig. 6;
Fig. 8 is a section showing an essential portion of the semiconductor integrated circuit device of Fig. 1 at a manufacture step subsequent to that of Fig. 7;
Fig. 9 is a section showing an essential portion of the semiconductor integrated circuit device of Fig. 1 at a manufacture step subsequent to that of Fig. 8;
Fig. 10 is a section showing an essential portion of the semiconductor integrated circuit device of Fig. 1 at a manufacture step subsequent to that of Fig. 9;
Fig. 11 is a section showing an essential portion of the semiconductor integrated circuit device of Fig. 1 at a manufacture step subsequent to that of Fig. 10;
Fig. 12 is a section showing an essential portion of a semiconductor integrated circuit device according to another embodiment of the present invention;
Fig. 13 is a section showing an essential portion of a semiconductor integrated circuit device according to still another embodiment of the present invention;
Fig. 14 is a section showing an essential portion of a semiconductor integrated circuit device according to a further embodiment of the present invention;
Fig. 15 is a section showing an essential portion of a semiconductor integrated circuit device according to a further embodiment of the present invention;
Fig. 16 is a section showing an essential portion of a semiconductor integrated circuit device according to a further embodiment of the present invention;
Fig. 17 is a section showing an essential portion of a semiconductor integrated circuit device according to a further embodiment of the present invention;
Fig. 18 is a section showing an essential portion of a semiconductor integrated circuit device according to a further embodiment of the present invention;
Fig. 19 is a section showing an essential portion of the semiconductor integrated circuit device of Fig. 18 at a manufacture step;
Fig. 20 is a section showing an essential portion of the semiconductor integrated circuit device of Fig. 18 at a manufacture step subsequent to that of Fig. 19;
Fig. 21 is a section showing an essential portion of the semiconductor integrated circuit device of Fig. 18 at a manufacture step subsequent to that of Fig. 20;
Fig. 22 is a section showing an essential portion of the semiconductor integrated circuit device of Fig. 18 at a manufacture step subsequent to that of Fig. 21;
Fig. 23 is a section showing an essential portion of the semiconductor integrated circuit device of Fig. 18 at a manufacture step subsequent to that of Fig. 22;
Fig. 24 is a section showing an essential portion of a semiconductor integrated circuit device according to a further embodiment of the present invention;
Fig. 25 is a section showing an essential portion of a semiconductor integrated circuit device according to a further embodiment of the present invention;
Fig. 26 is a section showing an essential portion of the semiconductor integrated circuit device of the further embodiment of the present invention at a manufacture step;
Fig. 27 is a section showing an essential portion of the semiconductor integrated circuit device of the further embodiment of the present invention at a manufacture step subsequent to that of Fig. 26;
Fig. 28 is a section showing an essential portion of the semiconductor integrated circuit device of the further embodiment of the present invention at a manufacture step subsequent to that of Fig. 27;
Fig. 29 is a section showing an essential portion of the semiconductor integrated circuit device of the further embodiment of the present invention at a manufacture step subsequent to that of Fig. 28;
Fig. 30 is a section showing an essential portion of the semiconductor integrated circuit device of the further embodiment of the present invention at a manufacture step;
Fig. 31 is a section showing an essential portion of the semiconductor integrated circuit device of the further embodiment of the present invention at a manufacture step subsequent to that of Fig. 30;
Fig. 32 is a section showing an essential portion of the semiconductor integrated circuit device of the further embodiment of the present invention at a manufacture step subsequent to that of Fig. 31;
Fig. 33 is a section showing an essential portion of the semiconductor integrated circuit device of the further embodiment of the present invention at a manufacture step subsequent to that of Fig. 32;
Fig. 34 is a section showing an essential portion of the semiconductor integrated circuit device of the further embodiment of the present invention;
Fig. 35 is a section showing an essential portion of the semiconductor integrated circuit device of the further embodiment of the present invention at a manufacture step subsequent to that of Fig. 34;
Fig. 36 is a section showing an essential portion of the semiconductor integrated circuit device of the further embodiment of the present invention at a manufacture step subsequent to that of Fig. 35;
Fig. 37 is a section showing an essential portion of the semiconductor integrated circuit device of the further embodiment of the present invention at a manufacture step subsequent to that of Fig. 36;
Fig. 38 is a section showing an essential portion of the semiconductor integrated circuit device of the further embodiment of the present invention at a manufacture step subsequent to that of Fig. 37;
Fig. 39 is a section showing an essential portion of the semiconductor integrated circuit device of the further embodiment of the present invention at a manufacture step subsequent to that of Fig. 38;
Fig. 40 is a section showing an essential portion of the semiconductor integrated circuit device of the further embodiment of the present invention at a manufacture step subsequent to that of Fig. 39;
Fig. 41 is a section showing an essential portion of a semiconductor integrated circuit device according to a further embodiment of the present invention;
Fig. 42 is a graph diagram plotting a depthwise impurity concentration distribution of a semiconductor substrate in the semiconductor integrated circuit device of the present invention;
Fig. 43 is a section showing an essential portion of a semiconductor integrated circuit device according to a further embodiment of the present invention;
Fig. 44 is a section showing an essential portion of a semiconductor integrated circuit device according to a further embodiment of the present invention; and
Fig. 45 is a section showing an essential portion of a semiconductor integrated circuit device according to a further embodiment of the present invention.

### DETAILED DESCRIPTION OF THE PREFERRED EMBODIMENTS

The present invention will be described in detail in the following in connection with its embodiments with reference to the accompanying drawings.

### (Embodiment 1)

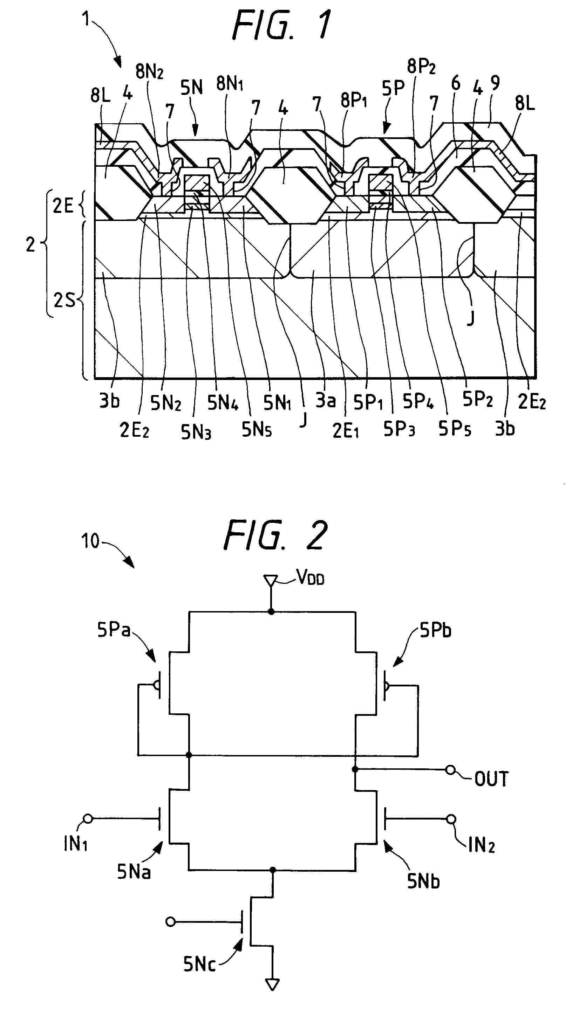

Fig. 1 is a section showing an essential portion of a semiconductor integrated circuit device according to one embodiment of the present invention; Fig. 2 is a circuit diagram showing an example of application of the semiconductor integrated circuit device of Fig. 1; and Figs. 3 to 11 are sections showing an essential portion of the semiconductor integrated circuit device of Fig. 1 at individual manufacture steps.

As shown in Fig. 1, a semiconductor substrate 2, as constructing a semiconductor integrated circuit device 1 of the present embodiment 1, is composed of a semiconductor substrate body 2S and an epitaxial layer (or a single crystalline semiconductor layer) 2E formed over the semiconductor substrate body 2S.

This semiconductor substrate body 2S is made of a p⁻-type silicon (Si) single crystal having a specific resistance of 10 Ωcm and a thickness of about 500 µm, for example. Specifically, the semiconductor substrate body 2S is homogeneously doped with a p-type impurity such as boron (B) in a dosage of about 1 × 10¹⁵ to 10 × 10¹⁵ atoms/cm³, preferably 1.3 × 10¹⁵ atoms/cm³.

In the upper portion of the semiconductor substrate body 2S, there are formed semiconductor regions, i.e., a well (or a first region) 3a and a well (or a second region) 3b which are adjacent to each other. These wells 3a and 3b are doped with impurities of different conduction types to form a PN junction J.

The well 3a is doped with an n-type impurity such as phosphor (P). On the other hand, the well 3b is doped with a p-type impurity such as boron. These wells 3a and 3b have an equal impurity concentration as high as a surface concentration of about 1 × 10¹⁷ atoms/cm³ or more. Incidentally, this surface concentration may be higher because no element is formed therein. In short, the well 3a provides an n-well, and the well 3b provides a p-well.

In the present embodiment 1, therefore, a punch-through voltage between the drain of a MOS·FET and the semiconductor substrate body 2S can be raised even if the wells 3a and 3b are not so deep. Moreover, the wells 3a and 3b can have their impurity concentrations set so high as to improve the latch-up breakdown voltage and the soft-error breakdown voltage.

Over the principal plane of the semiconductor substrate body 2S, there is formed the epitaxial layer 2E. Over this epitaxial layer 2E, an element forming region, as enclosed by an element isolating insulating film or field insulating film (or a first oxide film) 4, is formed with elements including a p-channel MOS·FET (as will be called the pMOS) 5P and an n-channel type MOS·FET (as will be called the nMOS) 5N.

The epitaxial layer 2E is made of a single crystalline Si having such a thickness, e.g., 0.3 µm to 3 µm as to retain the device characteristics and the reliability of the gate insulating film and as to allow the bottom portion of the field insulating film 4 to contact with the upper portion of the semiconductor substrate body 2S.

Of the epitaxial layer 2E, an epitaxial layer 2E1 over the well 3a is doped with an n-type impurity such as phosphor in an impurity concentration of 1 × 10¹⁵ to 10 × 10¹⁵ atoms/cm³, preferably 1.3 × 10¹⁵ atoms/cm³.

Of the epitaxial layer 2E, moreover, an epitaxial layer 2E2 over the well 3b is doped with a p-type impurity such as boron in an impurity concentration equal to that of the epitaxial layer 2E1 of 1 × 10¹⁵ to 10 × 10¹⁵ atoms/cm³, preferably 1.3 × 10¹⁵ atoms/cm³. In short, both the impurity concentrations of the epitaxial layers 2E1 and 2E2 are set lower than those of their underlying wells 3a and 3b.

Thus, in the present embodiment 1, the heavily doped wells 3a and 3b are overlain by the lightly doped epitaxial layer 2E, which is formed with the pMOS 5P and the nMOS 5N over its epitaxial layers 2E1 and 2E2, so that the following first to fifth effects can be achieved.

Firstly, the fluctuation of the element characteristics can be suppressed to improve the set accuracy of the element characteristics. This is because the pMOS 5P and the nMOS 5N are formed not directly in the wells 3a and 3b but over the lightly doped epitaxial layer 2E so that their characteristics (e.g., the threshold voltage or the substrate effect) can be accurately set without being influenced by the impurities of the wells 3a and 3b and the semiconductor substrate body 2S.

Secondly, the action rates of the semiconductor integrated circuit device can be improved. This is because the pMOS 5P and the nMOS 5N are formed over the lightly doped epitaxial layer 2E so that the junction capacity of the drain can be reduced to improve the tailing characteristics of the pMOS 5P and the nMOS 5N accordingly. Moreover, since the channel forming region is formed over the lightly doped epitaxial layer 2E, the inversion layer has its width enlarged to reduce the surface scattering so that the carrier mobility can be enhanced.

Thirdly, the circuit design of the semiconductor integrated circuit device can be facilitated. This is because the substrate effect can be lowered by forming the pMOS 5P and the nMOS 5N are formed over the lightly doped epitaxial layer 2E.

Moreover, the wells 3a and 3b can have their impurity concentrations set substantially independently of those of the pMOS 5P and the nMOS 5N so that the they can be set higher than those of the prior art. This is because the latch-up resistance of the CMOS (Complementary Metal Oxide Semiconductor) circuit can be improved to make the circuit layout design sufficient against the latch-up breakage. Moreover, it is possible to prevent the punch-through of the MOS·FET.

Fourthly, the time period for a thermal treatment to form the wells 3a and 3b can be shortened. This is because the wells 3a and 3b can have their impurity concentrations set to higher levels than those of the prior art substantially independently of those of the pMOS 5P and the nMOS 5N so that they can be made shallower than those of the prior art.

Fifthly, the pMOS 5P and the nMOS 5N can be formed in the lightly doped epitaxial layer 2E so that the junction breakdown voltage of the drain can be improved. Moreover, the carrier mobility can also be improved.

The field insulating film 4, as formed in the element isolating region, is made of a silicon oxide film such as silicon oxide (SiO₂), and the PN junction of the wells 3a and 3b terminates at the bottom of the field insulating film 4. Here in the case of the present embodiment 1, because of the high impurity concentrations of the wells 3a and 3b, there is little necessity for forming the channel stopper for setting a high threshold voltage against the parasitic MOS·FET below the field insulating film 4. In other words, the field insulating film 4 is extended over the semiconductor substrate body 2S more deeply than the epitaxial layer 2E.

As a result, the step of introducing the impurity for forming the channel stopper can be eliminated to shorten the time period for manufacturing the semiconductor integrated circuit device. Moreover, the parasitic capacity due to the channel stopper can be eliminated to improve the action speed of the semiconductor integrated circuit device. Still moreover, the drain breakdown voltage is regulated by the overlapping portion between the drain end portion and the end portion of the channel stopper so that the drain breakdown voltage can be raised.

The pMOS 5P is formed over the epitaxial layer 2E1. On the other hand, the nMOS 5N is formed over the epitaxial layer 2E2. Moreover, these pMOS 5P and nMOS 5N form a CMOS circuit.

The pMOS 5P has the following components: a pair of semiconductor regions (or seventh regions) 5P1 and 5P2 formed in the upper portion of the epitaxial layer 2E and spaced from each other; a punch-through stopper semiconductor region (or eighth region) 5P3 formed between the paired semiconductor regions 5P1 and 5P2; a gate insulating film 5P4 formed over the epitaxial layer 2E; and a gate electrode 5P5 formed over the gate insulating film 5P4. Incidentally, the punch-through stopper semiconductor region may be abbreviated to the punch-through stopper.

The semiconductor regions 5P1 and 5P2 are regions for forming the source/drain regions of the pMOS 5P and are doped with a p-type impurity such as boron. The impurity concentrations of the semiconductor regions 5P1 and 5P2 are about 0.5 × 10²⁰ to 5 × 10²⁰ atoms/cm³, preferably 1 × 10²⁰ atoms/cm³.

The semiconductor regions 5P1 and 5P2 are given such a thickness of about 0.1 µm as to come within the range of the thickness of the epitaxial layer 2E. In this case, the regions having the maximum impurity concentrations are as deep as about 0.04 µm to 0.07 µm.

The punch-through stopper 5P3 is a semiconductor region which is formed to improve the punch-through breakdown voltage between the semiconductor regions 5P1 and 5P2, so that the punch-through breakdown voltage between the source and the drain can be improved. Specifically, since the semiconductor regions 5P1 and 5P2 are formed in the lightly doped epitaxial layer 2E1, the punch-through stopper 5P3 is effective to improve the punch-through breakdown voltage.

The punch-through stopper 5P3 is doped with an n-type impurity such as phosphor. The punch-through stopper 5P3 has an impurity concentration higher than that of the epitaxial layer 2E1, as exemplified by 5 × 10¹⁶ to 1 × 10¹⁸ atoms/cm³, preferably 2 × 10¹⁷ atoms/cm³.

The depth of the punch-through stopper 5P3 is so set that the peak region of the impurity concentration may be located midway of the depth of the semiconductor regions 5P1 and 5P2. On the other hand, the depletion layer to extend depthwise from the semiconductor regions 5P1 and 5P2 can have its extension suppressed by the well 3a to improve the punch-through breakdown voltage between the source and the drain.

The gate insulating film 5P4 is made of SiO₂ (or a silicon oxide film) having a thickness of about 180 angstroms and formed over the epitaxial layer 2E. As a result, the following first and second effects can be achieved.

Firstly, the gate insulating film 5P4 can have its quality improved to raise its breakdown voltage. Secondly, the gate insulating film 5P4 can also have its defect density (i.e., the number of defects to be caused within a predetermined range) improved (or reduced) by one figure or more. Incidentally, the gate insulating film 5P4 is formed by thermally oxidizing the epitaxial layer 2E, for example. Moreover, the improvement in the breakdown voltage of the gate insulating film, as formed over the epitaxial layer, and the aforementioned thickness of the epitaxial layer are disclosed in U.S. Application Serial No. , as applied before U.S. Patent Office on July 28, 1995. Here, the content of this disclosure is inserted as a reference to the present invention.

The gate electrode 5P5 is made of a film of a poly-silicon single layer having a low resistance. However, the gate electrode 5P5 should not be limited to the low-resistance poly-silicon single film but could be modified in such various manners as to have a structure in which a silicide film of WSi₂ (or tungsten silicide) overlies the low-resistance poly-silicon film.

On the other hand, the nMOS 5N has the following components: a pair of semiconductor regions (or seventh regions) 5N1 and 5N2 formed in the upper portion of the epitaxial layer 2E and spaced from each other; a punch-through stopper semiconductor region (or eighth region) 5N3 formed between the paired semiconductor regions 5N1 and 5N2; a gate insulating film 5N4 formed over the epitaxial layer 2E; and a gate electrode 5N5 formed over the gate insulating film 5N4. Incidentally, the punch-through stopper semiconductor region may be abbreviated to the punch-through stopper.

The semiconductor regions 5N1 and 5N2 are regions for forming the source/drain regions of the pMOS 5N and are doped with an n-type impurity such as phosphor or arsenic (As). The impurity concentrations of the semiconductor regions 5N1 and 5N2 are about 0.5 × 10²⁰ to 5 × 10²⁰ atoms/cm³, preferably 1 × 10²⁰ atoms/cm³.

The semiconductor regions 5N1 and 5N2 are given such a thickness of about 0.1 µm as to come within the range of the thickness of the epitaxial layer 2E. In this case, the regions having the maximum impurity concentrations are as deep as about 0.04 µm to 0.07 µm.

Thus, semiconductor regions 5S1 and 5S2 are formed in the lightly doped epitaxial layer 2E so that they can contact with the epitaxial layer 2E to reduce the junction capacity of the drain.

The punch-through stopper 5N3 is a semiconductor region which is formed to improve the punch-through breakdown voltage between the semiconductor regions 5N1 and 5N2, so that the punch-through breakdown voltage between the source and the drain can be improved while suppressing the extension of the depletion layer. Specifically, since the semiconductor regions 5N1 and 5N2 are formed in the lightly doped epitaxial layer 2E2, the punch-through stopper 5N3 is effective to improve the punch-through breakdown voltage.

The punch-through stopper 5N3 is doped with an n-type impurity such as phosphor. The punch-through stopper 5N3 has an impurity concentration higher than that of the epitaxial layer 2E2, as exemplified by 5 × 10¹⁶ to 1 × 10¹⁸ atoms/cm³, preferably 2 × 10¹⁷ atoms/cm³. The depth of the punch-through stopper 5N3 is so set that the peak region of the impurity concentration may be located midway of the depth of the semiconductor regions 5N1 and 5N2. On the other hand, the depletion layer to extend depthwise from the semiconductor regions 5N1 and 5N2 can have its extension suppressed by the well 3b to improve the punch-through breakdown voltage between the source and the drain.

The gate insulating film 5N4 is made of SiO₂ (or a silicon oxide film) having a thickness of about 180 angstroms and formed over the epitaxial layer 2E. As a result, the following first and second effects can be achieved. As a result, there can be attained effects similar to those of the aforementioned pMOS 5P. Specifically, the gate insulating film 5N4 can have its quality improved to raise its breakdown voltage, and the gate insulating film 5N4 can also have its defect density improved by one figure or more.

The gate electrode 5N5 is made of a film of a poly-silicon single layer having a low resistance. However, the gate electrode 5N5 should not be limited to the low-resistance poly-silicon single film but could be modified in such various manners as to have a structure in which a silicide film of WSi₂ (or tungsten silicide) overlies the low-resistance poly-silicon film.

On this semiconductor substrate 2, there is deposited an insulating film 6 which is made of SiO₂, for example. This insulating film is formed in predetermined positions with connection holes 7 which expose the semiconductor regions 5P1 and 5P2 of the pMOS 5P and the semiconductor regions 5N1 and 5N2 of the nMOS 5N to the outside.

Moreover, the semiconductor regions 5P1 and 5P2 of the pMOS 5P are electrically connected through the connection holes 7 with electrodes 8P1 and 8P2, respectively. Moreover, the semiconductor regions 5N1 and 5N2 of the nMOS 5N are electrically connected through the connection holes 7 with electrodes 8N1 and 8N2, respectively. The electrodes 8P2 and 8N2 are formed integrally with a first-layer wiring line 8L. These electrodes 8P1, 8P2, 9N1 and 8N2 and the first-layer wiring line 8L are formed of a metal film which is made of an aluminum (Aℓ)-Si-Copper (Cu) alloy, for example.

On the insulating film 6, there is deposited a surface protecting film 9 which is formed by laminating a SiO₂ film (or silicon oxide film) and a silicon nitride (Si₃N₄) film sequentially in the recited order from the bottom so that the electrodes 8P1, 8P2, 8N1 and 8N2 and the first-layer wiring line 8L are coated. Incidentally, this semiconductor substrate 2 is sealed with the not-shown package resin.

Next, there is shown in Fig. 2 a circuit of the case in which the semiconductor integrated circuit device of the present embodiment 1 is applied to an analog circuit, for example. Fig. 2 shows a differential amplifier 10 as the analog circuit.

This differential amplifier 10 is composed of pMOSes 5Pa and 5Pb as load elements.

Input elements nMOSes 5Na and 5Nb have their respective gate electrodes electrically connected with input terminals IN1 and IN2. An nMOS 5Nc is an element for a constant current circuit.

The pMOS 5Pa and nMOS 5Na are connected in series between a supply voltage VDD and the nMOS 5Na composing the constant current circuit. Moreover, the nMOS 5Pb and the nMOS 5Nb are connected in series between the supply voltage VDD and the nMOS 5Na composing the constant current circuit. Incidentally, the wiring line for connecting the pMOS 5Pb and the nMOS 5Nb is electrically connected with an output terminal OUT.

The pMOSes 5Pa and 5Pb have their gate electrodes electrically connected with each other and with a wiring line for connecting the pMOS 5Pa and the nMOS 5Na electrically.

Next, a method of manufacturing the semiconductor integrated circuit device of the present embodiment 1 will be described with reference to Figs. 1 and 3 to 11.

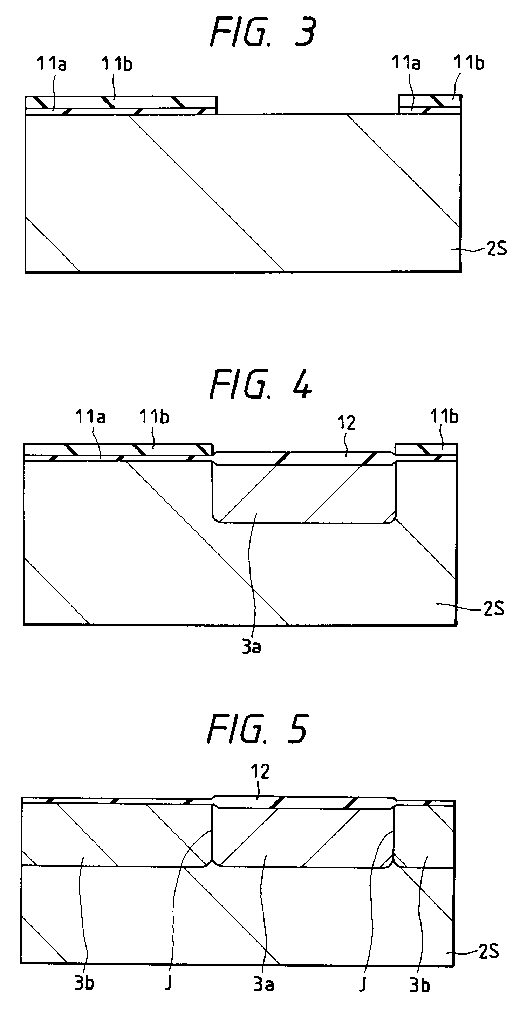

First of all, the semiconductor substrate body 2S made of a p-type silicon (Si) single crystalline wafer having a specific resistance of 10 Ωcm and a thickness of 500 µm, for example, is prepared, as shown in Fig. 3. This semiconductor substrate body 2S is doped with a p-type impurity of boron in a dosage of 1 × 10¹⁵ to 10 × 10¹⁵ atoms/cm³, preferably 1.3 × 10¹⁵ atoms/cm³, for example.

Subsequently, the semiconductor substrate body 2S is formed on its principal plane with an insulating film of SiO₂ by the thermal oxidation, and an insulating film of Si₃N₄ is then deposited on the former insulating film by the CVD (Chemical Vapor Deposition) method. Of those insulating films, moreover, the n-well forming region is removed by the photolithography and the etching technique to form insulating film patterns 11a and 11b.

After this, these insulating film patterns 11a and 11b are used as the masks to implant the principal plane of the semiconductor substrate body 2S with ions of an n-type impurity such as phosphor. After this, the semiconductor substrate body 2S is thermally oxidized to form the well 3a containing the n-type impurity over the semiconductor substrate body 2S, as shown in Fig. 4.

Incidentally, at this treatment, the exposed portion of the semiconductor substrate body 2S in the n-well forming region is formed with a thick insulating film 12 of SiO₂, for example.

Next, after the insulating film patterns 11a and 11b have been removed, the insulating film 12 is used as the mask to implant the principal plane of the semiconductor substrate body 2S with the ions of a p-type impurity, for example. By thermally treating the semiconductor substrate body 2S, moreover, the well 3b (or p-well) containing the p-type impurity is formed adjacent to the aforementioned well 3a over the semiconductor substrate body 2S.

Here, the wells 3a and 3b can have their impurity concentrations set to a level as high as 1 × 10¹⁷ atoms/cm³ or more. In the present embodiment 1, moreover, the punch-through breakdown voltage between the drain of the MOS·FET and the semiconductor substrate body 2S can be raised even if the wells 3a and 3b are not made so deep. Since the wells 3a and 3b can have their impurity concentrations set to the high level, it is also possible to improve the latch-up resistance and the soft-error resistance.

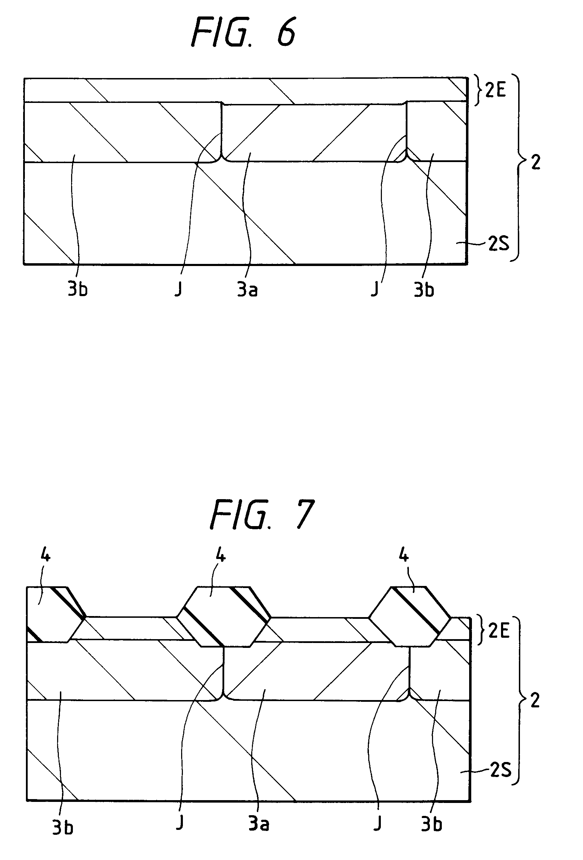

Subsequently, the semiconductor substrate body 2S is subjected to the CVD treatment (or the epitaxial growth) at about 800 to 1,000°C by using monosilane (SiH₄) gases and hydrogen (H₂) gases, to form the epitaxial layer 2E of the so-called "non-doped" single crystalline Si, which has a thickness of about 0.3 to 3.0 µm but contains no impurity, over the principal plane of the semiconductor substrate body 2S, as shown in Fig. 6. Thus, there is formed the semiconductor substrate 2 in which the epitaxial layer 2E is laminated over the semiconductor substrate body 2S.

After this, as shown in Fig. 7, the semiconductor substrate 2 is subjected to the LOCOS (Local Oxidation of Silicon) oxidation to form the field insulating film 4 in the element isolating region. Here in the present embodiment 1, the bottom portion of the field insulating film 4 reaches the upper portion of the semiconductor substrate body 2S.

In the present embodiment 1, however, the impurity concentrations of the wells 3a and 3b can be set to the high level to isolate the elements satisfactorily so that the channel stopper need hardly be formed below the field insulating film 4.

As a result, the step of introducing the impurity for forming the channel stopper can be reduced to shorten the time period for manufacturing the semiconductor integrated circuit device. Moreover, since the parasitic capacity to be caused by the channel stopper can be eliminated, the action speed of the semiconductor integrated circuit device can be improved. Still moreover, although the drain breakdown voltage is regulated by the superposed portions between the drain end portion and the end portion of the channel stopper, this channel stopper can be eliminated to improve the drain breakdown voltage.

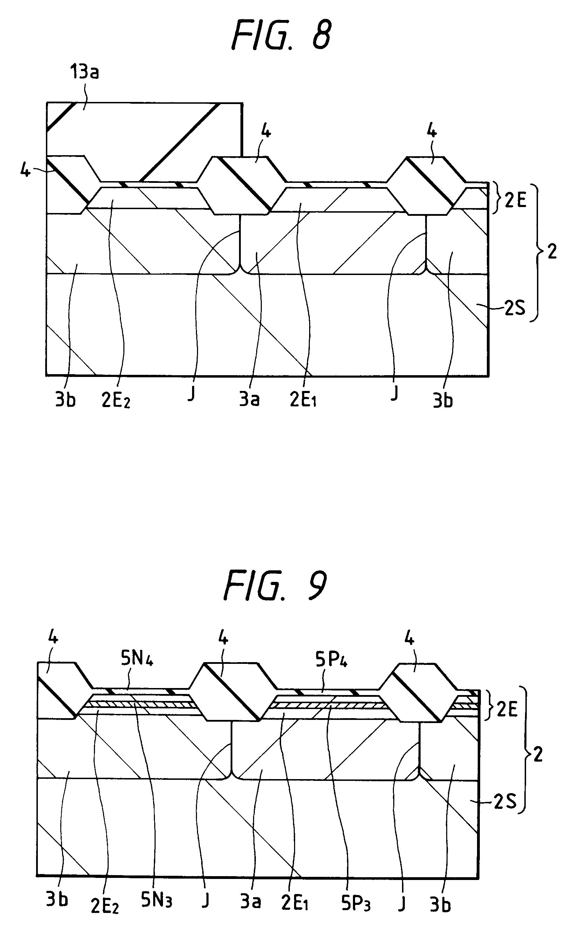

Next, as shown in Fig. 8, a photoresist pattern 13a, as exposes the region of the well 3a, is used as the mask to implant the epitaxial layer 2E1 over the well 3a with the ions of an n-type impurity such as phosphor. The dosage at this time is about 1 × 10¹¹ ions/cm². Here, the photoresist pattern 13a is formed of a photoresist film.

Subsequently, the photoresist pattern 13a is removed, and the (not-shown) photoresist pattern for exposing the region of the well 3b is then formed and used as the mask to implant the epitaxial layer 2E2 over the well 3b with the ions of a p-type impurity such as boron. The dosage at this time is about 1 × 10¹¹ ions/cm².

After this, the semiconductor substrate 2 is subjected to a thermal treatment to set the impurity concentrations of the epitaxial layers 2E1 and 2E2 to preset values thereby to control the electric characteristics such as the threshold voltage Vth of the MOS·FET to be formed in that region.

Here, the epitaxial layers 2E1 and 2E2 are doped all over their regions with the impurity. However, the doping should not be limited thereto, but the impurity may be introduced into only the channel region of the MOS·FET. Moreover, this impurity introduction may be done before the LOCOS oxidation for forming the field insulating film 4.

After the semiconductor substrate 2 has been formed thereover with the (not-shown) photoresist pattern through which the region of the epitaxial layer 2E1 is exposed, and this photoresist pattern is used as the mask for implanting the epitaxial layer 2E1 with the ions of an n-type impurity such as phosphor through the (not-shown) through film. The dosage at this time is about 1 × 10¹² ions/cm².

Subsequently, after the photoresist pattern has been removed, the (not-shown) photoresist pattern, through which the region of the epitaxial layer 2E2 is exposed, is formed and used as the mask to implant the epitaxial layer 2E2 with a p-type impurity such as boron through the (not-shown) through film. The dosage at this time is about 1 × 10¹ ions/cm².

After this, the semiconductor substrate 2 is subjected to the thermal treatment to form the punch-through stoppers 5P3 and 5N3 in the epitaxial layer 2E, as shown in Fig. 9. These punch-through stoppers 5P3 and 5N3 have their depths set to form their maximum peak portions in a position of a depth of bout 0.05 µm from the principal plane of the epitaxial layer 2E. Here, the through film is formed of a silicon oxide film, for example, by the thermal oxidation or the CVD method.

Next, after the aforementioned through films have been removed, the epitaxial layers 2E1 and 2E2 are formed thereover with the gate insulating films 5P4 and 5N4 by the thermal oxidation or the like.

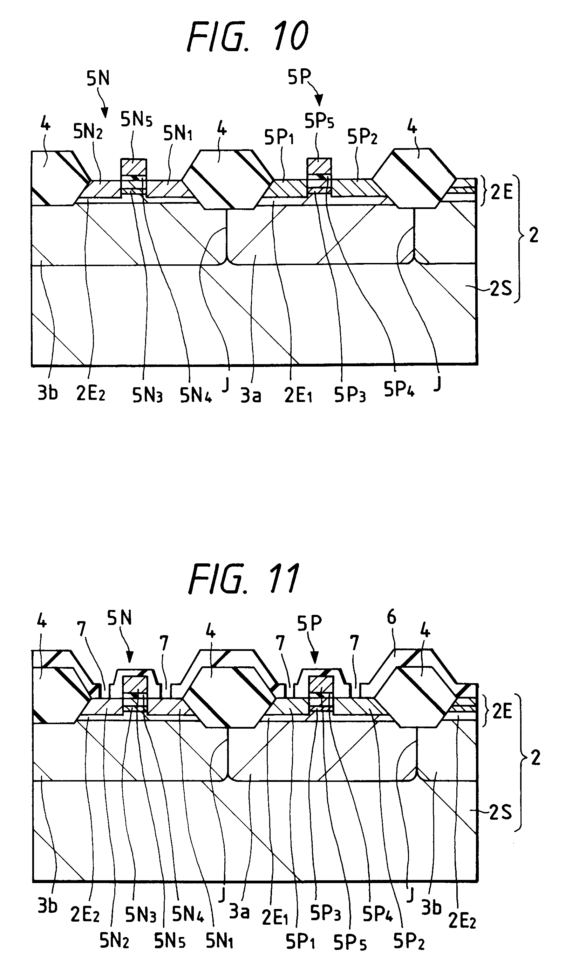

Subsequently, after a conductor film of low-resistance poly-silicon has been deposited on the semiconductor substrate 2 by the CVD method or the like, it is patterned by the photolithography or the CVD method to form the gate electrodes 5P5 and 5N5 over the gate insulating films 5P4 and 5N4, as shown in Fig. 10.

After this, the paired semiconductor regions 5P1, 5P2, 5N1 and 5N2 are formed in self-alignment with the gate electrodes 5P5 and 5N5 by doping impurities of different conduction types into the epitaxial layers 2E1 and 2E2 by using the gate electrodes 5P5 and 5N5 as the different photoresist masks. Thus, the pMOS 5P is formed over the epitaxial layer 2E1, and the nMOS 5N is formed over the epitaxial layer 2E2.

The impurity concentrations of those semiconductor regions 5P1, 5P2, 5N1 and 5N2 are about 0.5 × 10²⁰ to 5 × 10²⁰ atoms/cm³, preferably 1 × 10²⁰ atoms/cm³. Moreover, the semiconductor regions 5P1, 5P2, 5N1 and 5N2 have their bottom portions set deeper than the punch-through stoppers 5P3 and 5N3 but shallower than the wells 3a and 3b.

Next, as shown in Fig. 11, the insulating film 6 of SiO₂, for example, is deposited over the semiconductor substrate 2 by the CVD method or the like. After this, the insulating film 6 is formed with the connection holes 7 for exposing the semiconductor regions 5P1, 5P2, 5N1 and 5N2 by the photolithography and the etching technique.

Subsequently, there is deposited on the semiconductor substrate 2 the conductor film of an Aℓ-Si-Cu alloy by the sputtering method or the evaporation method. After this, the conductor film is patterned by the photolithography or the etching technique, to form the electrodes 8P1, 8P2, 8N1 and 8N2 and the first-layer wiring line 8L, as shown in Fig. 1.

After this, the SiO₂ film and the Si₃N₄ film are sequentially laminated in the recited order from the bottom over the semiconductor substrate 2. After this, the surface passivation film 9 is partially formed with bonding pad connection holes to end the manufacture of the semiconductor integrated circuit device.

Thus, the following effects can be achieved according to the present embodiment 1:
(1) The heavily doped wells 3a and 3b are overlain by the lightly doped epitaxial layer 2E having the epitaxial layers 2E1 and 2E2, on which are mounted the pMOS 5P and the nMOS 5N. As a result, these pMOS 5P and nMOS 5N can have their characteristics (e.g., the threshold voltage or the substrate effects) accurately set without being influenced by the impurities in the wells 3a and 3b and the semiconductor substrate body 2S. As a result, the pMOS 5P and the nMOS 5N can have their characteristic fluctuations suppressed to improve the setting accuracy of the characteristics.
(2) The pMOS 5P and the nMOS 5N are mounted on the lightly doped epitaxial layers 2E1 and 2E2 so that the junction capacity of the drain can be reduced. As a result, the pMOS 5P and the nMOS 5N can have their tailing characteristics improved to improve the carrier mobility. As a result, it is possible to improve the action speed of the semiconductor integrated circuit device.
(3) The pMOS 5p, the nMOS 5N and so on are formed in the epitaxial layer 2E. As a result, it is possible to reduce the substrate effects and to improve the carrier mobility.
(4) The heavily doped wells 3a and 3b are overlain by the lightly doped epitaxial layer 2E, on which are mounted the pMOS 5P and the nMOS 5N. As a result, the impurity concentrations of the wells 3a and 3b can be set substantially independently of the characteristics of the pMOS 5P and the nMOS 5N so that the impurity concentrations of the wells 3a and 3b can be set to higher levels than those of the prior art.
(5) Thanks to the aforementioned effect (4), it is possible to improve the latch-up resistance of the CMOS circuit.
(6) Thanks to the aforementioned effect (5), it is possible to make the circuit layout design sufficient for the latch-up breakage.
(7) Thanks to the aforementioned effect (4), it is possible to improve the soft-error resistance.
(8) Thanks to the aforementioned effect (4), it is possible to improve the punch-through resistance in the semiconductor substrate.
(9) Thanks to the aforementioned effects (3) and (6), it is possible to facilitate the circuit design of the semiconductor integrated circuit device.
(10) Thanks to the aforementioned effect (4), it is possible to make the wells 3a and 3b shallower than those of the prior art, so that the time period for thermally treating the wells 3a and 3b can be drastically shortened. In case the treating temperature is held constant, for example, the time period can be shortened from six hours in the prior art to about thirty minutes.
(11) Thanks to the aforementioned effect (10), it is possible to drastically reduce the warp and the crystal defect of the semiconductor substrate body 2S due to the thermal treatment.
(12) Thanks to the aforementioned effect (4), no channel stopper need be formed below the field insulating film 4 so that the step of introducing the impurity for forming the channel stopper can be eliminated. This makes it possible to shorten the time period for manufacturing the semiconductor integrated circuit device.
(13) Thanks to the aforementioned effect (4), no channel stopper need be formed below the field insulating film 4 so that the step of introducing the impurity for forming the channel stopper can be eliminated. This makes it possible to prevent the crystal defect or the like of the semiconductor substrate body 2S due to the impurity introduction.
(14) Thanks to the aforementioned effect (4), no channel stopper need be formed below the field insulating film 4 so that the parasitic capacity due to the channel stopper can be eliminated. This makes it possible to improve the action speed of the semiconductor integrated circuit device.
(15) Thanks to the aforementioned effect (4), no channel stopper need be formed below the field insulating film 4. As a result, it is possible to improve the drain breakdown voltage which is regulated by the superposed portion between the drain end portion and the end portion of the channel stopper.
(16) The pMOS 5P, the nMOS 5N and so on are formed in the lightly doped epitaxial layer 2E so that the junction breakdown voltage of the drain can be improved.
(17) The gate insulating films 5P4 and 5N4 of the pMOS 5P and the nMOS 5N are formed over the epitaxial layer 2E so that the gate insulating films 5P4 and 5N4 can have their film qualities improved to improve their breakdown voltages.
(18) The gate insulating films 5P4 and 5N4 of the pMOS 5P and the nMOS 5N are formed over the epitaxial layer 2E so that the gate insulating film 5P4 can have its defect density improved (or reduced) by one figure or more.
(19) The pMOS 5P and the nMOS 5N formed in the lightly doped epitaxial layer 2E are formed with the punch-through stoppers 5P3 and 5N3, respectively, so that the punch-through breakdown voltages between the individual sources-drains of the pMOS 5P and the nMOS 5N can be improved.
(20) The differential amplifier 10 is constructed of the MOS·FETs having the present structure so that the film qualities of the gate insulating films of the pMOSes 5Pa and 5Pb and the nMOSes 5Na to 5Nc composing the differential amplifier 10 can be improved to provide the differential amplifier 10 having less noises, especially less 1/f noises.
(21) The differential amplifier 10 is constructed of the MOS·FETs having the present structure so that the sources-drains of the pMOSes 5Pa and 5Pb and the nMOSes 5Na to 5Nc composing the differential amplifier 10 have their bottom faces contacting with the epitaxial layer 2E. As a result, the load capacity can be reduced to increase the cut-off frequency thereby to improve the high-frequency characteristics of the differential amplifier 10.
(22) The differential amplifier 10 is constructed of the MOS·FETs having the present structure so that the substrate effect can be reduced to determine the threshold voltage uniquely with the amount of ion implantation by the channel doping. As a result, it is possible to reduce the offset voltages of the nMOSes 5Na and 5Nb used for the differentiation.
(23) The differential amplifier 10 is constructed of the MOS·FETs having the present structure so that the sources-drains of the pMOSes 5Pa and 5Pb and the nMOSes 5Na to 5Nc composing the differential amplifier 10 are formed in the lightly doped epitaxial layer 2E. As a result, the sub-threshold coefficient in the low current region can be reduced, that is, the gradient of the current-voltage characteristics can be increased to effect the low-voltage actions.
(24) The differential amplifier 10 is constructed of the MOS·FETs having the present structure so that the early voltage can be raised by properly selecting the distance from the boundary between the punch-through stoppers 5P3 and 5N3 and the gate insulating films 5P4 and 5N4. As a result, it is possible to increase the gain of the differential amplifier 10.

### (Embodiment 2)

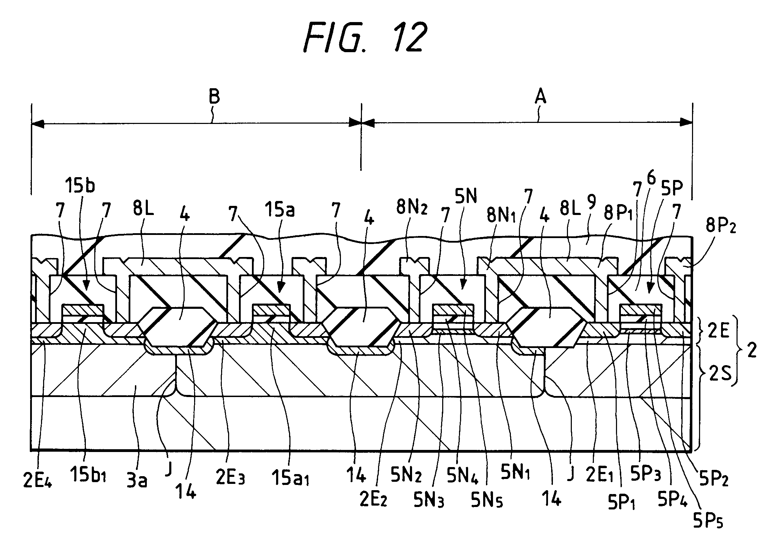

Fig. 12 is a section showing an essential portion of a semiconductor integrated circuit device according to another embodiment of the present invention.

We have specifically investigated the case in which the structure of the foregoing embodiment 1 is applied to a semiconductor integrated circuit device having an electrostatic protection circuit to be added between an input/output circuit and a power supply, and have found that the dielectric breakdown voltage of the elements for the electrostatic protection circuit may drop if the present structure is used.

Generally speaking, the elements for the electrostatic protection circuit are frequently made of either the MOS·FETs or the horizontal bipolar transistors which are parasitically formed below the field insulating film.

In this case, the majority carriers to be produced by the avalanche phenomenon of the collector/base junction generate the base current, to discharge the minority carriers by driving the bipolar transistors.

In case, however, the structure of the foregoing embodiment 1 is applied to a semiconductor integrated circuit device having the electrostatic protection circuit, the impurity concentration of the base region in the elements for the electrostatic protection circuit may have the vertical direction. In other words, the impurity concentration may be uneven in the depthwise direction of the semiconductor substrate. Especially the horizontal bipolar transistor, as formed below the MOS·FET, never fails to have that distribution.

Moreover, this impurity distribution causes a deviation in the minority carrier distribution in the base region at the drive time of the bipolar transistor thereby to invite the current concentration in the collector/base junction so that the dielectric breakdown voltage in the elements for the electrostatic protection circuit drops.

The present embodiment 2 proposes a structure for solving that problem. This structure will be described with reference to Fig. 12. In Fig. 12, the righthand side shows an internal circuit region A, and the lefthand side shows an electrostatic protection circuit region B.

The construction of the internal circuit is similar to that of the foregoing embodiment 1. In the present embodiment 2, however, in the region where the well containing the p-type impurity or boron and the field insulating film 4 are in contact, there is formed a channel stopper 14. This channel stopper 14 is doped with a p-type impurity such as boron. The impurity concentration is exemplified by 1 × 10¹⁷ to 5 × 10¹⁷ atoms/cm³, preferably 2 × 10¹⁷ atoms/cm³.

This is because the p-type impurity of boron may diffuse at the time of forming the field insulating film 4 so that its concentration may not be sufficiently retained in that contact region. In order to compensate this, the channel stopper 14 is formed. In the remaining points, the construction is similar to that of the foregoing embodiment 1.

The electrostatic protection circuit region B is formed with a horizontal npn bipolar transistor 15a and a horizontal pnp bipolar transistor 15b. In the present embodiment 2, the epitaxial layers 2E3 and 2E4 in this electrostatic protection circuit region B have their impurity concentrations set to equal to or higher than those of the wells 3a and 3b. In short, the impurity concentrations of the epitaxial layers 2E3 and 2E4 are set to about 1 × 10¹⁷ atoms/cm³ or more.

Here, the epitaxial layers 2E3 and 2E4 are formed to have their impurity distributions set as uniformly as possible in their entirety or their impurity concentrations raised at their surface portions.

As a result, it is possible to eliminate the regions of the epitaxial layers 2E3 and 2E4, where the concentrations are locally lower, thereby to eliminate the deviation of the minority carriers in the base regions 15a1 and 15b1 at the action times of the bipolar transistors 15a and 15b for the electrostatic protection circuit.

As a result, any local current concentration can be prevented from occurring in the epitaxial layers 2E3 and 2E4 to produce the electric current uniformly in the collector/base junction so that the electrostatic breakdown voltage can be prevented from dropping in the bipolar transistors 15a and 15b for the electrostatic protection circuit.

These epitaxial layers 2E3 and 2E4 have their impurity concentrations set by the ordinary photolithography technique and ion implantation technique, for example.

Specifically, the semiconductor substrate 2 is formed thereon with the (not-shown) photoresist pattern for exposing the region of the epitaxial layer 2E3, and this photoresist pattern is then used as the mask for implanting the epitaxial layer 2E3 with an n-type impurity such as phosphor through the (not-shown) through film. The dosage at this time is exemplified by 1 × 10¹³ ions/cm².

Subsequently, the photoresist pattern is removed, and the (not-shown) photoresist pattern for exposing the region of the epitaxial layer 2E4 is then formed and used as the mask to implant the epitaxial layer 2E4 with a p-type impurity such as boron through the (not-shown) through film. The dosage at this time is exemplified by 1 × 10¹³ ions/cm².

After this, the semiconductor substrate 2 is subjected to a thermal treatment to set the impurity concentrations and distributions of the epitaxial layers 2E3 and 2E4.

Thus, in the present embodiment 2, the following effects can be attained in addition to the effects (1) to (11) and (16) to (24), as obtained in the foregoing embodiment 1.

Specifically, the impurity concentrations of the epitaxial layers 2E3 and 2E4 in the electrostatic protection circuit region B are set equal to or higher than those of the wells 3a and 3b so that the impurity distributions in the epitaxial layers 2E3 and 2E4 may be as homogeneous as possible in their entirety or so that the impurity concentrations of the epitaxial layers 2E3 and 2E4 may be higher in their surface portions. As a result, it is possible to eliminate the regions in the epitaxial layers 2E3 and 2E4, where the concentrations are locally lower, thereby to eliminate the deviation of the minority carriers in the base regions at the action times of the bipolar transistors 15a and 15b for the electrostatic protection circuit. As a result, the local current concentration can be prevented from occurring in the epitaxial layers 2E3 and 2E4, to produce a uniform current flow in the collector/base junction so that the electrostatic breakdown voltages in the bipolar transistors 15a and 15b for the electrostatic protection circuit can be prevented from dropping.

### (Embodiment 3)

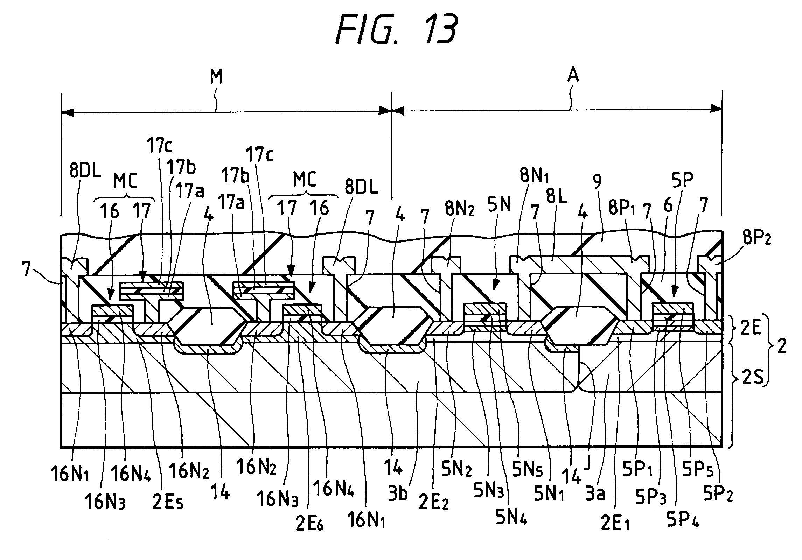

Fig. 13 is a section showing an essential portion of a semiconductor integrated circuit device according to still another embodiment of the present invention.

We have specifically investigated the case in which the structure of the foregoing embodiment 1 is applied to a semiconductor integrated circuit device having a DRAM (Dynamic RAM (Random Access Memory)), and have found that the carrier holding characteristics may drop in the capacity element portion of the DRAM if the present structure is used.

In the case of a memory circuit, the holding characteristics of the carriers, as latched in the capacity element portion, are an important performance index. These holding characteristics are substantially determined by the amount of charge, as stored in the capacity element portion, and the pn junction leakage current of the memory circuit, but have to be considered for the so-called "soft-error phenomenon", in which the stored charge disappears due to the influences of the electron-hole pair to be produced by the alpha ray emitted to the semiconductor substrate from the radioactive substance contained in the wiring line and the sealing resin material.

Here, in case the structure of the aforementioned embodiment 1 is applied to the memory circuit, the junction capacity is small, and there is no impurity region of high concentration excepting the wells 3a and 3b. As a result, no barrier layer may be for the carriers produced in the wells 3a and 3b by the alpha ray, thereby to lower the holding characteristics.

The present embodiment 3 proposes a structure for solving that problem. This structure will be described with reference to Fig. 13. In Fig. 13, the righthand side shows the internal circuit region A, and the lefthand side shows a memory cell array M.

The construction of the internal circuit is similar to that of the foregoing embodiment 1. In the present embodiment 3, however, for the same reason as that of the foregoing embodiment 2, the channel stopper 14 is formed in the region in which the well 3b containing the p-type impurity such as boron and the field insulating film 4 are in contact. The remaining construction is identical to that of the foregoing embodiment 1.

The memory cell array M is arranged with a plurality of memory cells MC. Each of these memory cells MC of the DRAM is composed of a transfer MOS·FET 16 and a capacitor (or capacity element) 17.

The transfer MOS·FET 1 is composed of the following components: a pair of semiconductor regions 16N1 and 16N2 formed over the epitaxial layer 2E and spaced from each other; a gate insulating film 16N3 formed over the epitaxial layer 2E; and a gate electrode 16N4 formed over the gate insulating film 16N3.

The semiconductor regions 16N1 and 16N2 are regions forming the source/drain regions of the transfer MOS·FET 16 and are doped with an n-type impurity such as phosphor or arsenic.

The impurity concentrations of the semiconductor regions 16N1 and 16N2 are exemplified by 1 × 10¹⁸ to 5 × 10²⁰ atoms/cm³, preferably 3 × 10¹⁸ atoms/cm³. The semiconductor regions 16N1 and 16N2 have their depths set to fall within the range of the thickness of the epitaxial layer 2E. In the memory cells of the DRAM, the source/drain concentration is lower than that of the MOSFETs composing the peripheral circuits.

One semiconductor region 16N1 is electrically connected with a data line 8DL through the connection hole 7 which is formed in the insulating film 6. The data line 8D1 is made of an Aℓ-Si-Cu alloy, for example, and is formed simultaneously with the first-layer wiring line 8L and so on.

The other semiconductor region 16N2 is electrically connected with the capacitor 17. This capacitor 17 is composed of the following components: a lower electrode 17a electrically connected with one semiconductor region 16N2 of the transfer MOS·FET 16; a capacitative insulating film 17b formed over the lower electrode 17a; and an upper electrode 17c formed over the capacitative insulating film 17b.

The lower electrode 17a is formed of a conductor film of low-resistance poly-silicon or tungsten silicide (WSi₂). The capacitative insulating film 17b is formed of an insulating film of Si₃N₄ or tantalum oxide (TaO₃). Moreover, the upper electrode 17c is formed of a conductor film of low-resistance poly-silicon or WS₂.

Incidentally, in the present embodiment 3, the epitaxial layers 2E5 and 2E6 in this memory cell MC have their impurity concentrations set equal to or higher than those of the wells 3a and 3b. Specifically, the impurity concentrations of the epitaxial layers 2E5 and 2E6 are set to 1 × 10¹⁷ atoms/cm³ or more.

As a result, it is possible to increase the junction capacity of the epitaxial layers 2E5 and 2E6 between the semiconductor regions 16N1 and 16N2 and the epitaxial layers 2E5 and 2E6 and to form the barrier layer for prevent the carriers produced due to the electron-hole pairs by the alpha ray from invading the capacitor 17. As a result, the memory holding characteristics from dropping even in case the structure of the foregoing embodiment 1 is applied to the semiconductor integrated circuit device having the DRAM. Specifically, the barrier layer for reducing the invasion of the carriers, which are produced due to the electron-hole pairs by the alpha ray, from the well 3b into the epitaxial layers 2E5 and 2E6 can be established by the well 3b and the epitaxial layers 2E5 and 2E6.

These epitaxial layers 2E5 and 2E6 have their impurity concentrations set by the ordinary photolithography technique and the ion implantation technique, for example, after the gate insulating films 5P4, 5N4 and the 16N3 have been formed.

Specifically, the semiconductor substrate 2 is formed thereon at first with the (not-shown) photoresist pattern for exposing the epitaxial layers 2E5 and 2E6 in the memory cell array M. After this, the photoresist pattern is used as the mask for implanting the epitaxial layers 2E5 and 2E6 with the ions of an n-type impurity such as phosphor through the (not-shown) through film. The dosage at this time is exemplified by 1 × 10¹³ ions/cm². After this, the semiconductor substrate 2 is subjected to a thermal treatment to set the impurity concentrations and distributions of the epitaxial layers 2E3 and 2E4.

Thus, in the present embodiment 3, the following effects can be achieved in addition to the effects (1) to (11) and (16) to (24), as obtained in the foregoing embodiment 1.

Specifically, the impurity concentrations of the epitaxial layers 2E5 and 2E6 in the memory cell array M are set equal to or higher than those of the wells 3a and 3b so that the junction capacity in the epitaxial layers 2E5 and 2E6 can be increased while forming the barrier layer for preventing the carriers, which are produced due to the electron-hole pairs by the alpha ray, from invading the capacitor 17. As a result, it is possible to prevent the reduction of the memory holding characteristics of the semiconductor integrated circuit device having the DRAM.

### (Embodiment 4)

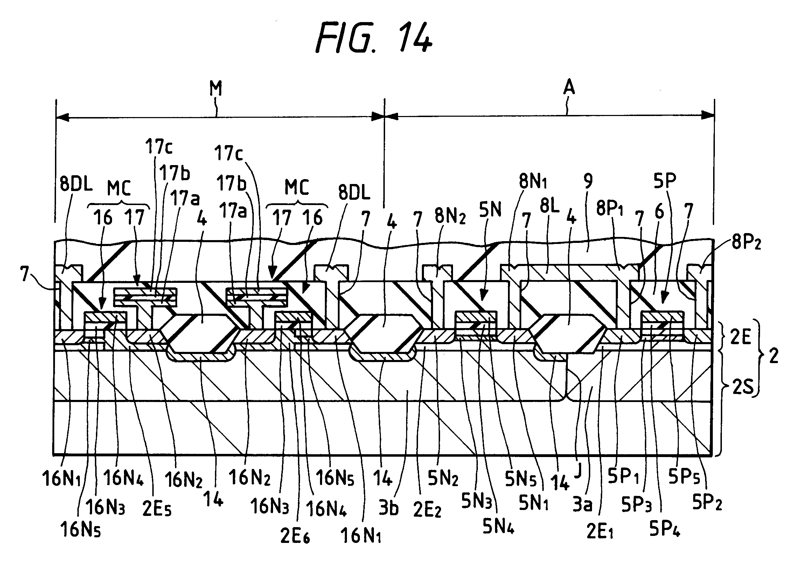

Fig. 14 is a section showing an essential portion of a semiconductor integrated circuit device according to a further embodiment of the present invention.

The semiconductor integrated circuit device of the present embodiment 4 is exemplified by a semiconductor integrated circuit device having the same DRAM as that of the foregoing embodiment 3. In the present embodiment 4, however, in the epitaxial layers 2E5 and 2E6 of the memory cell array M, only the layer below the semiconductor region 16N2 to be connected with the capacitor 17 and its neighborhood have their impurity concentrations set equal to or higher than those of the wells 3a and 3b, as shown in Fig. 14.

Moreover, the layer below the semiconductor region 16N1 to be connected with the data line 8DL and its neighborhood have their impurity concentrations set to levels as low as those of the foregoing embodiment 1, and the lightly doped region is formed as in the foregoing embodiment 1 with a punch-through stopper (or an eighth region) 16N5. The remaining construction is similar to that of the foregoing embodiment 3. Specifically, the layer below the semiconductor region 16N1 and its neighborhood have their impurity concentrations set, over and below the punch-through stopper 16N5, to levels as low as those of the embodiment 1.

As a result, in the present embodiment 4, the effects of the foregoing embodiment 4 can be attained without increasing the load capacity of the data line 8DL. Specifically, it is possible to prevent both the reductions of the data transfer rate and the memory holding characteristics of the semiconductor integrated circuit device having the DRAM.

### (Embodiment 5)

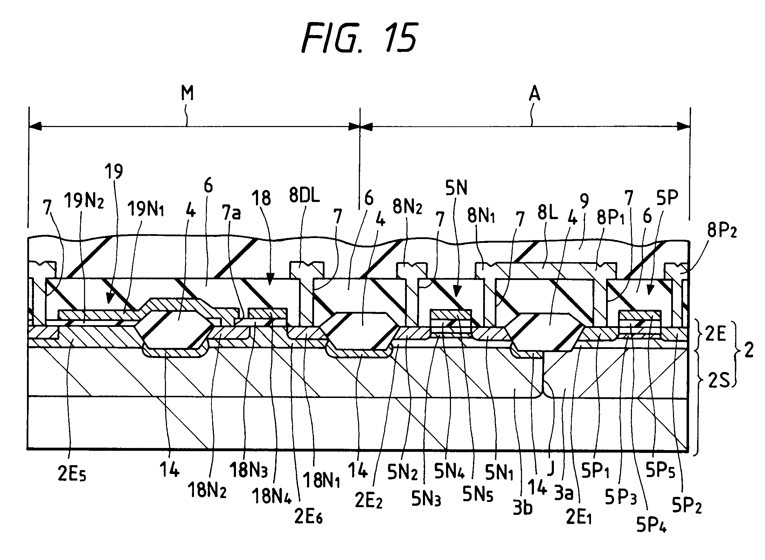

Fig. 15 is a section showing an essential portion of a semiconductor integrated circuit device according to a further embodiment of the present invention.

The present embodiment 5 will be described in connection with the case in which the structure of the foregoing embodiment 1 is applied to a semiconductor integrated circuit device having a SRAM (Static RAM).

In this case, too, there arises a problem similar to that of the foregoing embodiment 3. Specifically, the problem is the reduction in the memory holding characteristics. The present embodiment 5 proposes a structure for solving the problem, as will be described with reference to Fig. 15. In Fig. 15, the righthand side shows the internal circuit region A, and the lefthand side shows the memory cell array M.

The construction of the internal circuit is similar to that of the foregoing embodiment 1. In the present embodiment 5, however, for the same reason as that of the foregoing embodiment 2, the channel stopper 14 is formed in the region in which the well containing the p-type impurity of boron and the field insulating film 4 are in contact with each other. The remaining construction is identical to that of the foregoing embodiment 1.

The memory cell array M is arranged with a transfer MOS·FET 18 and a driver MOS·FET 19. Each memory cell of the SRAM is composed of a pair of driver MOS·FETs 19, a pair of transfer MOS·FETs 18, and a pair of load elements. The paired driver MOS·FETs are cross-connected.

The transfer MOS·FET 18 is composed of the following components: a pair of semiconductor regions 18N1 and 18N2-formed over the epitaxial layer 2E and spaced from each other; a gate insulating film 18N3 formed over the epitaxial layer 2E; and a gate electrode formed over the gate insulating film 18N3.

The semiconductor regions 18N1 and 18N2 are regions for forming the source/drain regions of the transfer MOS·FET 18 and are doped with an n-type impurity such as phosphor or arsenic.

The impurity concentrations of the semiconductor regions 18N1 and 18N2 are exemplified by 0.5 × 10²⁰ to 5 × 10²⁰ atoms/cm³, preferably 1 × 10²⁰ atoms/cm³. The semiconductor regions 5N1 and 5N2 have their depths set to fall within the range of the thickness of the epitaxial layer 2E.

One semiconductor region 18N1 of the transfer MOS·FET 18 is electrically connected with the data line 8DL through the connection hole 7 which is formed in the insulating film 6. The other semiconductor region 18N2 of the transfer MOS·FET 18 is electrically connected with a gate electrode 19N1 of the driver MOS·FET 19 through a connection hole 7a. Like the semiconductor regions 18N1 and 18N2 of the transfer MOS·FET 18, the (not-shown) semiconductor regions forming the source/drain regions of the driver MOS·FET 19 are formed in the epitaxial layers 2E5 and 2E6.

In the present embodiment 5, the impurity concentrations of the epitaxial layers 2E5 and 2E6 in the memory cell array M are set equal to or higher than those of the wells 3a and 3b. Specifically, the impurity concentrations of the epitaxial layers 2E5 and 2E6 are exemplified by 1 × 10¹⁷ atoms/cm³ or higher.

As a result, it is possible to increase the junction capacity in the epitaxial layers 2E5 and 2E6 between the drain region of the driver MOS·FET 19 and the epitaxial layers 2E5 and 2E6 and to form a barrier layer for preventing the carriers produced due to the electron-hole pairs by the alpha ray, as in the foregoing embodiment 3, from invading the data holding portion. Thus, it is possible to prevent the reduction in the memory holding characteristics of the semiconductor integrated circuit device having the SRAM.

Incidentally, the impurity concentrations of the epitaxial layers 2E5 and 2E6 are set as in the foregoing embodiment 3 by the ordinary photolithography technique and the ion implantation technique, for example, after the gate insulating films 5P4, 5N4, 18N3 and 19N2 have been formed.

Thus, according to the present embodiment 5, the following effects can be achieved in addition to the effects (1) to (11) and (16) to (24), as obtained in the foregoing embodiment 1.

Specifically, the impurity concentrations of the epitaxial layers 2E5 and 2E6 in the memory cell array M are set equal to or higher than those of the wells 3a and 3b so that the junction capacity in the epitaxial layers 2E5 and 2E6 can be increased while forming the barrier layer for preventing the carriers, which are produced due to the electron-hole pairs by the alpha ray, from invading the information holding portion. As a result, it is possible to prevent the reduction of the memory holding characteristics.

### (Embodiment 6)

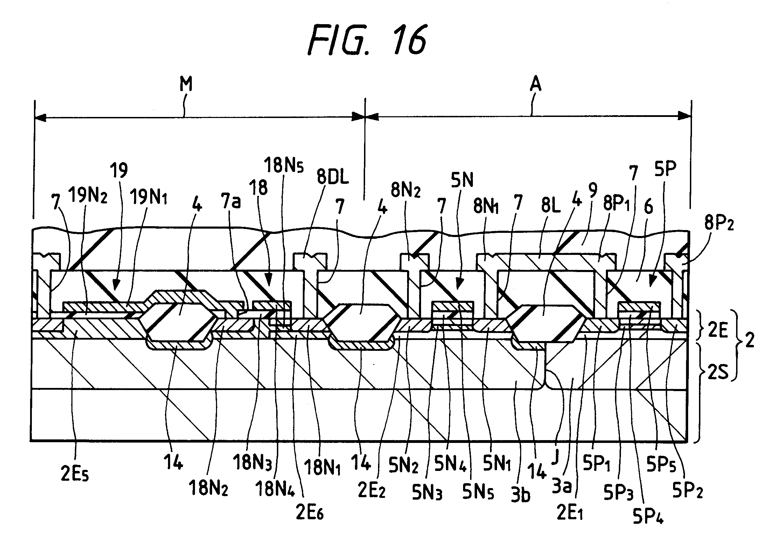

Fig. 16 is a section showing an essential portion of a semiconductor integrated circuit device according to a further embodiment of the present invention.

The semiconductor integrated circuit device of the present embodiment 6 is a semiconductor integrated circuit device having the SRAM as in the foregoing embodiment 5.

In the present embodiment 6, however, in the epitaxial layers 2E5 and 2E6 of the memory cell array M, only the layers below the region to be formed with the driver MOS·FET 19 and the semiconductor region 18N2 to be connected with the gate electrode 19N1 of the driver MOS·FET 19, and their neighborhoods have their impurity concentrations set equal to or higher than those of the wells 3a and 3b, as shown in Fig. 16.

Of the semiconductor regions 18N1 and 18N2 of the transfer MOS·FET 18, moreover, the layer below the semiconductor region 18N1 to be connected with the data line 8DL and its neighborhood have their impurity concentrations set to levels as low as those of the foregoing embodiment 1, and the lightly doped region is formed as in the foregoing embodiment 1 with a punch-through stopper 18N5. The remaining construction is similar to that of the foregoing embodiment 5. Specifically, the layer below the semiconductor region 18N1 and its neighborhood have their impurity concentrations set, over and below the punch-through stopper 18N5, to levels as low as those of the embodiment 1.

As a result, in the present embodiment 6, the effects of the foregoing embodiment 5 can be attained without increasing the load capacity of the data line 8DL. Specifically, it is possible to prevent both the reductions of the data transfer rate and the memory holding characteristics of the semiconductor integrated circuit device having the SRAM.

### (Embodiment 7)

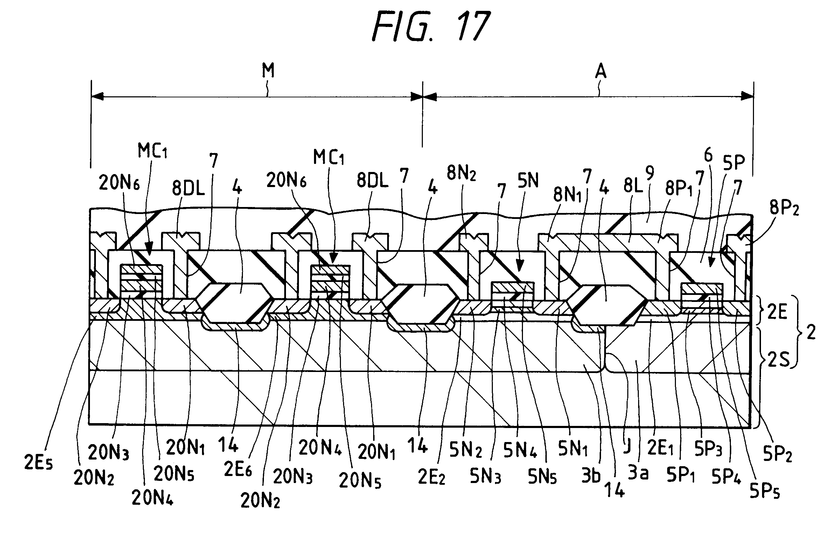

Fig. 17 is a section showing an essential portion of a semiconductor integrated circuit device according to a further embodiment of the present invention.

The present embodiment 7 will be described in connection with the case in which the present invention is applied to a semiconductor integrated circuit device having an EEPROM (Electrically Erasable Programmable ROM).

In Fig. 17, the righthand side shows the internal circuit region A, and the lefthand side shows the memory cell array M.

The construction of the internal circuit is similar to that of the foregoing embodiment 1. In the present embodiment 7, too, the channel stopper 14 is formed for the same reason as that of the foregoing embodiment 2 in the region in which the well 3b containing the p-type impurity of boron and the field insulating film 4 are in contact. The remaining construction is identical to that of the foregoing embodiment 1.

The memory cell array M is arranged with a plurality of memory cells MC1. The memory cell MC1 of this case is composed of the following components.

Specifically, the components are: a pair of semiconductor regions 20N1 and 20N2 formed over the epitaxial layer 2E and spaced from each other; a gate insulating film 20N3 formed over the epitaxial layer 2E; a floating gate electrode 20N4 formed over the gate insulating film 20N3; an insulating film 20N5 formed over the floating gate electrode 20N4; and a control gate electrode 20N6 formed over the insulating film 20N5.

The semiconductor regions 20N1 and 20N2 are doped with an n-type impurity of phosphor or arsenic. The impurity concentrations of the semiconductor regions 20N1 and 20N2 are preferably exemplified by 1 × 10²⁰ atoms/cm³.

The semiconductor regions 20N1 and 20N2 are made so deep as to fall within the range of the thickness of the epitaxial layer 2E. One semiconductor region 20N1 is electrically formed with the data line 8DL through the connection hole 7 which is formed in the insulating film 6.

The floating gate electrode 20N4 is an electrode for storing the charge to contribute to the storage of information. The control gate electrode 20N6 is an electrode for controlling storage and discharge of the charge to contribute to the information storage. Both the floating gate electrode 20N4 and the control gate electrode 20N6 are made of low-resistance poly-silicon.

Here in the present embodiment 7, the epitaxial layers 2E5 and 2E6 in the memory cell array M have their impurity concentrations set equal to or higher than those of the wells 3a and 3b. Specifically, the impurity concentrations of the epitaxial layers 2E5 and 2E6 are set to 1 × 10¹⁷ atoms/cm³ or more.

Incidentally, the impurity concentrations of the epitaxial layers 2E5 and 2E6 are set by the ordinary photolithography technique and the ion implantation technique, for example, after the gate insulating films 5P4, 5N4, 18N3 and 19N2 have been formed as in the foregoing embodiment 3.

Since the impurity concentrations of the epitaxial layers 2E5 and 2E6 in the memory cell array M are set equal to or higher than those of the wells 3a and 3b, it is possible to increase the junction capacity in the epitaxial layers 2E5 and 2E6.

### (Embodiment 8)

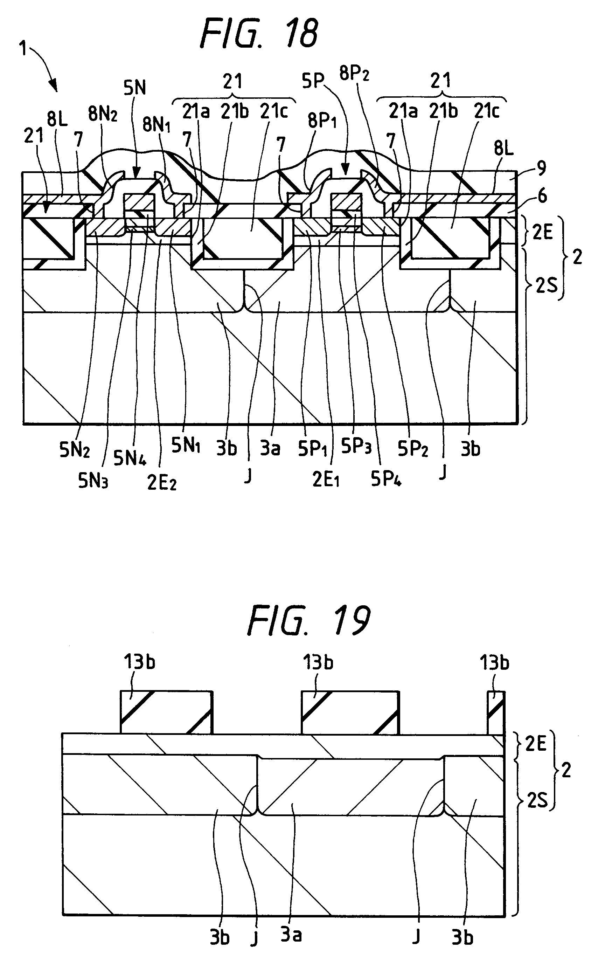

Fig. 18 is a section showing an essential portion of a semiconductor integrated circuit device according to a further embodiment of the present invention, and Figs. 19 to 23 are sections showing an essential portion of the semiconductor integrated circuit device of Fig. 18 at manufacture steps.

In the present embodiment 8, the element isolating portion has a channel structure, as shown in Fig. 18. The remaining construction is similar to that of the foregoing embodiment 1.

An element isolating portion 21 is formed by burying insulating films 21b and 21c in a channel 21a which is formed to reach the wells 3a and 3b of the semiconductor substrate 2. The insulating film 21b, as formed on the surface of the channel 21a, is made of SiO₂, for example, by the thermal oxidation method or the like. The insulating film 21b has a thickness of about 1,000 angstroms.

The reason why this insulating film 21b is formed by the thermal oxidation method is as follows. Specifically, the surface of the channel 21a is a portion to come into direct contact with the semiconductor substrate body 2S and the junction of the wells 3a and 3b and exerts serious influences upon the element characteristics. In order to protect that portion, therefore, the insulating film 21b is formed by the thermal oxidation method for providing an excellent film quality.

On the other hand, the other insulating film 21c in the channel 21a is made of SiO₂, for example, by the SOG (Spin On Glass) method or the like. Incidentally, the method of forming the insulating film 21c should not be limited to the SOG method but may be exemplified by the CVD method.

Next, the process for manufacturing the semiconductor integrated circuit device of the present embodiment 8 will be described with reference to Figs. 18 to 23.

First of all, as shown in Fig. 19, the epitaxial layer 2E of the semiconductor substrate 2 is formed thereover with a photoresist pattern 13b for exposing the element isolating region by the photolithography technique. At this stage, no impurity is contained in the epitaxial layer 2E. Moreover, the semiconductor substrate body 2S is formed thereover with the wells 3a and 3b.

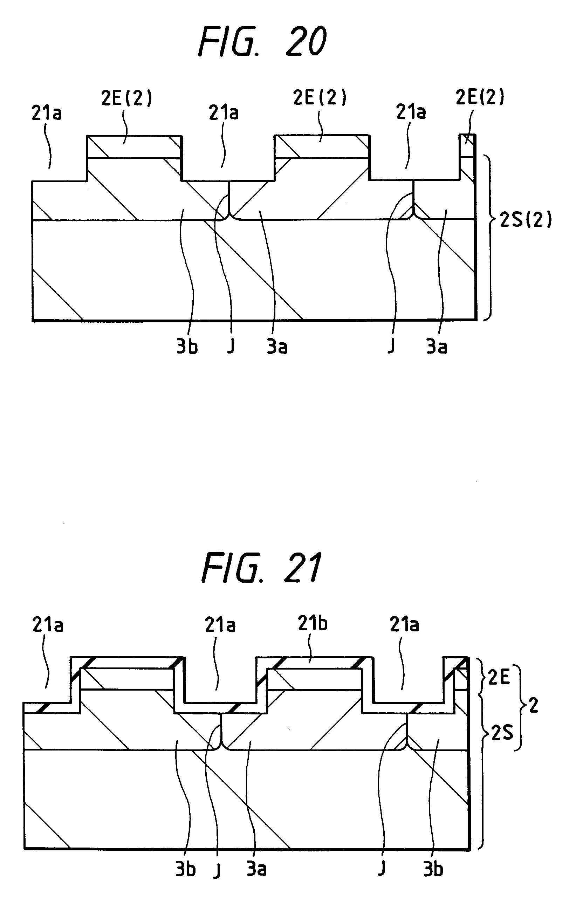

Subsequently, this photoresist pattern 13b is used as the etching mask to etch off the epitaxial layer 2E and the upper portions of the semiconductor substrate body 2S, as exposed from the photoresist pattern 13b, by the dry-etching method, for example, thereby to form the channel 21a in the element isolating region, as shown in Fig. 20.

After this, the semiconductor substrate 2 is subjected to the thermal oxidation treatment, for example, to form the insulating film 21b of SiO₂ having a thickness of about 1,000 angstroms over the principal plane of the semiconductor substrate 2 formed with the channel 21a, as shown in Fig. 21.

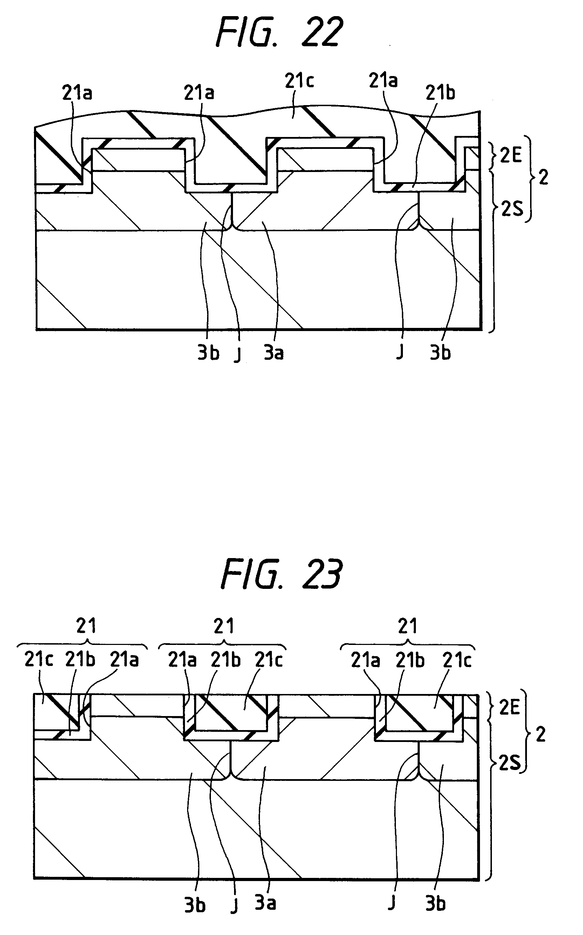

After this, the insulating film 21c made of SiO₂, for example, is deposited on the insulating film 21b by the SOG method or the like, as shown in Fig. 22. After this, the insulating film 21c has its upper portion so removed to flatten the upper surface of the semiconductor substrate 2, as shown in Fig. 23, by the etch-back method or the CMP (Chemical Mechanical Polishing) method that it may be left only in the channel 21a. Incidentally, the subsequent steps will not be described because they are similar to those of the foregoing embodiment 1.

Thus, according to the present embodiment 8, the following effects can be achieved in addition to those obtained in the foregoing embodiment 1.
(1) Thanks to the channel structure, the element isolating portion 21 can be easily formed even if the epitaxial layer 2E is thick.
(2) Thanks to the channel structure, the element isolating portion 21 can be formed without enlarging its occupation area so that the degree of integration of the elements can be improved.
(3) Thanks to the channel structure of the element isolating portion 21, the chip size can be made smaller for the same number of elements than that of the case in which the element isolating portion is formed of a field insulating film.
(4) Since the channel 21a forming the element isolating portion 21 is formed on its surface with the insulating film 21b by the thermal oxidation method, the epitaxial layer 2E in the channel 21a, the semiconductor substrate body 2S and the junction of the adjoining wells 3a and 3b can be satisfactorily protected to improve the reliability and production yield of the semiconductor integrated circuit device 1.
(5) Thanks to the channel structure of the element isolating portion 21, the flatness of the upper surface of the semiconductor substrate 2 can be drastically improved to improve the transfer accuracy of the wiring pattern thereover and the wiring reliability. As a result, it is possible to improve the reliability and the production yield of the semiconductor integrated circuit device 1.

### (Embodiment 9)

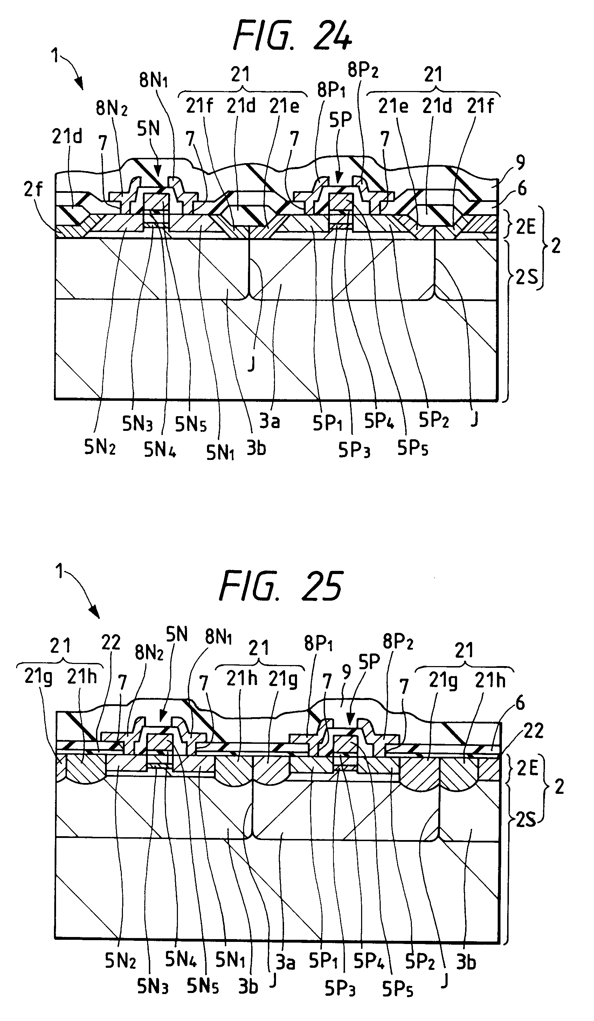

Fig. 24 is a section showing an essential portion of a semiconductor integrated circuit device according to a further embodiment of the present invention.

In the present embodiment 9, as shown in Fig. 24, the element isolating portion 21 is formed of a field insulating film (or second oxide film), and two semiconductor regions 21e and 21f of different conduction types formed below the field insulating film 21d and adjacent to each other. The remaining construction is similar to that of the foregoing embodiment 1.

These semiconductor regions 21e and 21f are extended from the lower face of the field insulating film 21d to the upper portions of the wells 3a and 3b.

The semiconductor region (or third region) 21e over the well 3a is doped with an impurity of the same conduction type as that of the impurity contained in the well 3a such as an n-type impurity of phosphor.

On the other hand, the semiconductor region (or fourth region) 21f over the well 3b is doped with an impurity of the same conduction type as that of the impurity contained in the well 3b such as a p-type impurity of boron.

Such element isolating portion 21 is formed by the following manner. First of all, the regions for individually forming the semiconductor regions 21e and 21f are doped with individual impurities for the element isolations by using the (not-shown) different photoresist patterns as the masks.

Subsequently, the semiconductor substrate 2 is formed thereover with the(not-shown) pad film of SiO₂, for example, by the thermal oxidation method or the like, and this pad film is formed thereover with the (not-shown) oxidation-resistant insulating film of Si₃N₄, for example.

After this, of the pad film and the oxidation-resistant insulating film, the portions of the element isolating regions are removed by the dry-etching method or the like to expose the epitaxial layer 2E. After this, the semiconductor substrate 2 is subjected to the LOCOS oxidizing treatment to form the field insulating film 21d and the two semiconductor regions 21e and 21f below the former.

Thus, according to the present embodiment 9, the following effects can be achieved in addition to the effects (1) to (11) and (16) to (24), as obtained by the foregoing embodiment 1.

Specifically, the element isolating portion 21 is formed of the field insulating film 21d and the two semiconductor regions 21e and 21f of different conduction types formed below the field insulating film 21d and adjacent to each other. As a result, the element isolating portion 21 can be easily formed even if the epitaxial layer 2E is thick.

### (Embodiment 10)

Fig. 25 is a section showing an essential portion of a semiconductor integrated circuit device according to a further embodiment of the present invention.

In the present embodiment 10, as shown in Fig. 25, the element isolating portion 21 is formed of two semiconductor regions of different conduction types arranged adjacent to each other.

These two semiconductor regions 21g and 21h are extended to reach from the principal plane of the epitaxial layer 2E to the upper portions of the wells 3a and 3b.

The semiconductor region (or fifth region) 21g over the well 3a is doped with an impurity of the same conduction type as that of the impurity contained in the well 3a, such as an n-type impurity of phosphor. On the other hand, the semiconductor region (or sixth region) 21h over the well 3b is coped with an impurity of the same conduction type as that of the impurity contained in the well 3b, such as a p-type impurity of boron.

Such element isolating portion 21 may be formed, for example, by doping the regions for individually forming the semiconductor regions 21g and 21h with the individual element isolating impurities by the (not-shown) separate photoresist patterns and then by treating the semiconductor substrate 2 thermally.

In the present embodiment 10, moreover, the epitaxial layer 2E has its upper surface coated with an insulating film 22 which is formed by the thermal oxidation method or the like. As a result, it is possible to protect the epitaxial layer 2E and the junction of the adjacent semiconductor regions 21g and 21h.

Thus, according to the present embodiment 10, the following effects can be achieved in addition to the effects (1) to (11) and (16) to (24), as obtained by the foregoing embodiment 1.
(1) Since the element isolating portion 21 is formed of the semiconductor regions 21g and 21h, the flatness of the upper surface of the semiconductor substrate 2 can be drastically improved to improve the transfer accuracy of the wiring pattern over the semiconductor substrate 2 and accordingly the wiring reliability. As a result, it is possible to improve the reliability and production yield of the semiconductor integrated circuit device.
(2) Since the epitaxial layer 2E has its upper surface coated with the insulating film 22 which is formed by the thermal oxidation method, the epitaxial layer 2E and the junction of the semiconductor regions 21g and 21h can be satisfactorily protected to improve the reliability and production yield of the semiconductor integrated circuit device.

### (Embodiment 11)

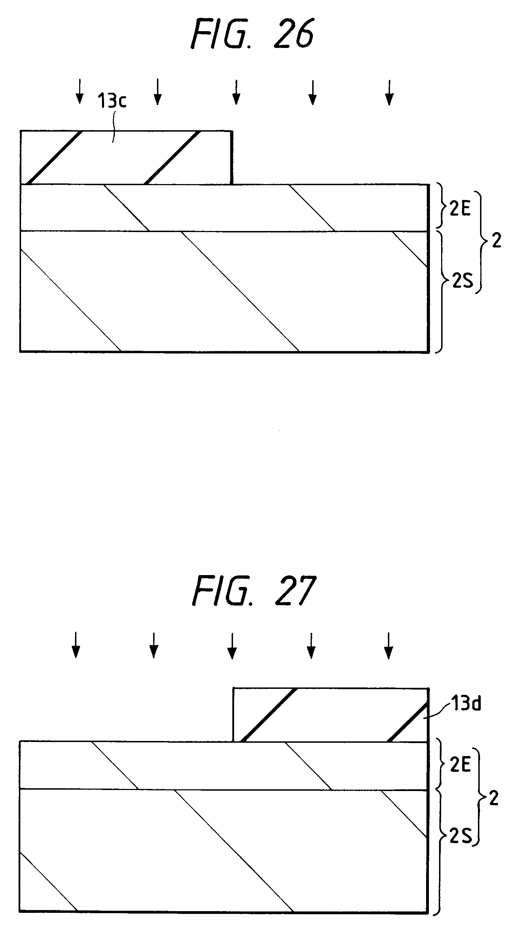

Figs. 26 to 29 are sections showing an essential portion of a semiconductor integrated circuit device at manufacture steps according to a further embodiment of the present invention.

The present embodiment 11 is a modification of the well forming method, as described in the foregoing embodiment 1 and so on. The process for manufacturing the semiconductor integrated circuit device of the present embodiment 11 will be described with reference to Figs. 26 to 29.

Fig. 26 is a section showing an essential portion of the semiconductor substrate 2 in the semiconductor integrated circuit device manufacturing process of the present embodiment 11. Over the semiconductor substrate body 2S, there has already been formed the non-doped epitaxial layer 2E by the same method as that of the foregoing embodiment 1.

Over the epitaxial layer 2E, moreover, there is formed a photoresist pattern 13c for exposing only one well forming region to the outside. This photoresist pattern 13c is given a thickness of about 2 µm to 3 µm.

First of all, this semiconductor substrate 2 is implanted with ions of an n-type impurity of phosphor, for example, by a high energy by using the photoresist pattern 13c as the etching pattern.

The ion implanting energy at this time is as high as to bring the n-type impurity ions to the upper portion of the semiconductor substrate body 2S, such as 300 KeV to 800 KeV, preferably about 450 KeV. Moreover, the dosage at this time is exemplified by 1 × 10¹³ to 3 × 10¹³ ions/cm², preferably 1.5 × 10¹³ ions/cm².

Subsequently, the photoresist pattern 13c is removed, and a photoresist pattern 13d for exposing only the other well forming region is formed, as shown in Fig. 27. After this, this photoresist pattern 13d is used as the mask to implant the semiconductor substrate 2 with the ions of a p-type impurity of boron, for example, by a high energy.

The ion implanting energy at this time is as high as to bring the p-type impurity ions to the upper portion of the semiconductor substrate body 2S, such as 150 KeV to 500 KeV, preferably about 200 KeV. Moreover, the dosage at this time is exemplified by 1 × 10¹³ to 3 × 10¹³ ions/cm², preferably 1.5 × 10¹³ ions/cm².

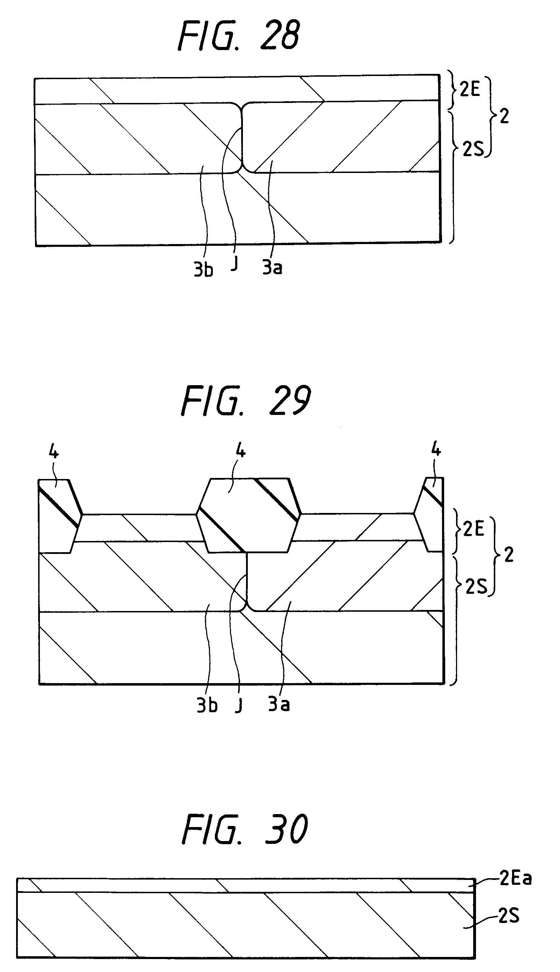

After this, the semiconductor substrate 2 is subjected to a thermal treatment to form the wells 3a and 3b in the upper portion of the semiconductor substrate body 2S and in the lower portion of the epitaxial layer 2E, as shown in Fig. 28.

After this, the field insulating film 4 is formed in the element isolating region as in the foregoing embodiment 1 by the LOCOS oxidation method or the like, as shown in Fig. 29. The subsequent steps will not be described because they are similar to those of the foregoing embodiment 1.

Thus, the present embodiment 11 can achieve effects similar to those of the foregoing embodiment 1.

### (Embodiment 12)

Figs. 30 to 33 are sections showing an essential portion of a semiconductor integrated circuit device at manufacture steps according to a further embodiment of the present invention.

The present embodiment 12 is a modification of the punch-through stopper forming method, as described in the foregoing embodiment 1 and so on. The process for manufacturing the semiconductor integrated circuit device of the present embodiment 12 will be described with reference to Figs. 30 to 33.

However, the present embodiment 12 can be applied to the case, in which there is no well having the conduction type opposite to that of the semiconductor substrate body, that is, to the process for manufacturing the semiconductor integrated circuit device having MOS·FETs of either an n-channel or p-channel type.

Fig. 30 is a section showing an essential portion of the semiconductor substrate body 2S in the process for manufacturing the semiconductor integrated circuit device of the present embodiment 12. Over the semiconductor substrate body 2S, there has already been formed a non-doped epitaxial layer 2Ea by the same method as that of the foregoing embodiment 1.

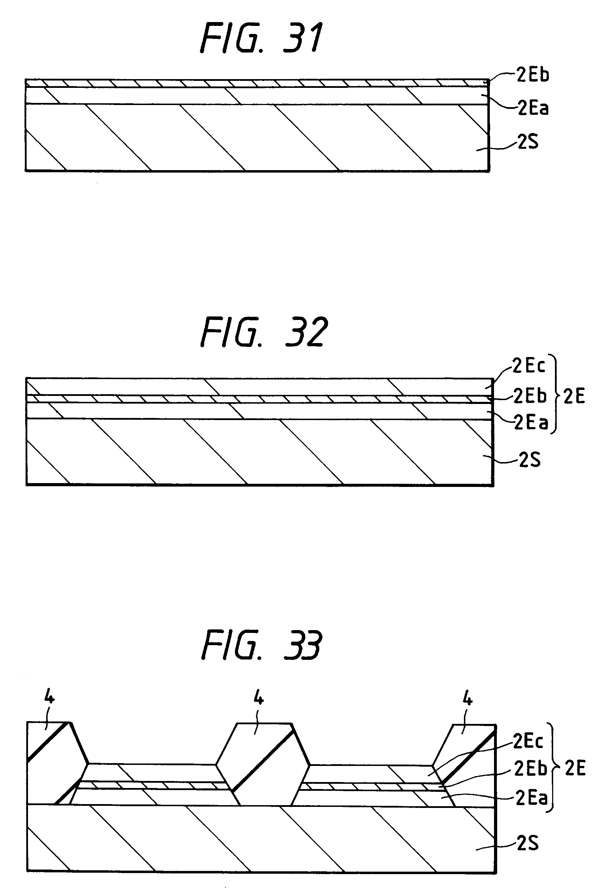

First of all, over the epitaxial layer 2Ea, as shown in Fig. 31, there is grown an epitaxial layer 2Eb, as is made of single crystalline Si doped with a p-type impurity of boron, by the CVD method (or epitaxial method). This epitaxial layer 2Eb is used as the punch-through stopper.

Subsequently, over the epitaxial layer 2Ea, as shown in Fig. 32, there is continuously grown an epitaxial layer 2Ec which is made of non-doped single crystalline Si.

After this, like the foregoing embodiment 1, the element isolating region is formed with the field insulating film,4, for example, by the LOCOS oxidation method, as shown in Fig. 33. At the subsequent steps, a predetermined semiconductor integrated circuit device may be manufactured according to the ordinary MOS·FET manufacture process.

Thus, according to the present embodiment 12, the following effects can be achieved in addition to those of the foregoing embodiment 1.

Specifically, the impurity introducing step for forming the punch-through stopper can be eliminated by forming the punch-through stopper by the epitaxial growth. As a result, the control for the impurity introduction can be eliminated to facilitate the manufacture of the semiconductor integrated circuit device.

### (Embodiment 13)

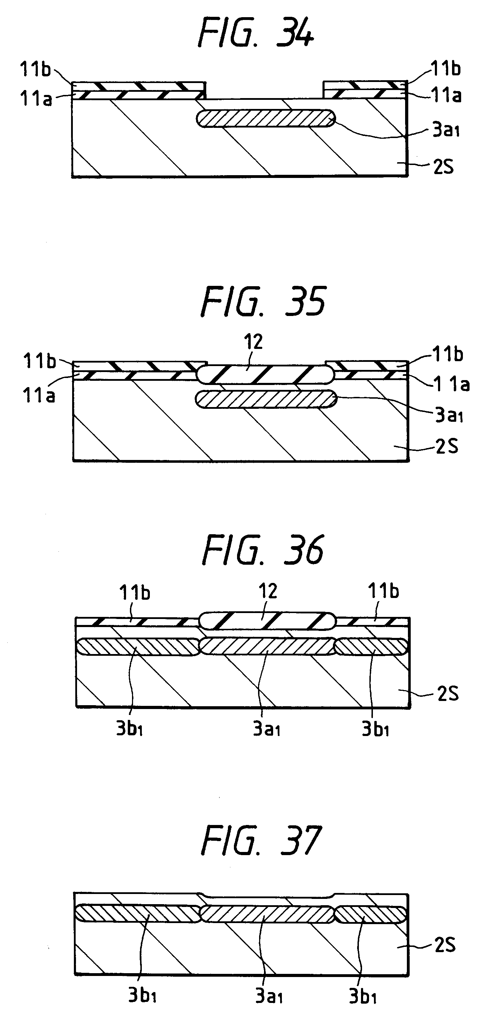

Figs. 34 to 40 are sections showing an essential portion of a semiconductor integrated circuit device at manufacture steps according to a further embodiment of the present invention.

In connection with the present embodiment 13, one example of the well forming method will be described with reference to Figs. 34 to 40.

First of all, as shown in Fig. 34, the semiconductor substrate body 2S has its principal plane formed thereover by the thermal oxidation method or the like with an insulating film of SiO₂ or the like, on which is deposited an insulating film of Si₃N₄ or the like by the CVD method or the like. Of this insulating film, moreover, the n-well forming region is removed by the photolithography technique and the etching technique to form the insulating film patterns 11a and 11b. Incidentally, the semiconductor substrate body 2S is identical to that of the foregoing embodiment 1.

Subsequently, those insulating film patterns 11a and 11b are used as the masks to implant the principal plane of the semiconductor substrate body 2S with the ions of an n-type impurity as the n-well forming impurity. The acceleration voltage at this time is exemplified by about 120 KeV, and the dosage is exemplified by about 1 × 10¹³ ions/cm². Incidentally, reference characters 3a1 indicates the region which is implanted with the n-well forming impurity.

After this, the portion, as exposed from the insulating film patterns 11a and 11b, is formed with the insulating film 12, as shown in Fig. 35, by thermally oxidizing the semiconductor substrate body 2S. Here, this thermal oxidation is done under such conditions (e.g., temperature or time period) that the well forming n-type impurity introduced into the semiconductor substrate body 2S may not diffuse.

Subsequently, the insulating film pattern 11b is removed, and the insulating film 12 is then used as the mask to implant the principal plane of the semiconductor substrate body 2S with the ions of the p-well forming impurity such as the p-type impurity of boron or boron fluoride (BF₂), as shown in Fig. 36. At this time, the acceleration voltage is exemplified by about 60 KeV, and the dosage is exemplified by about 8 × 10¹² ions/cm². Incidentally, reference characters 3b1 indicates the region which is implanted with the p-well forming impurity.

Subsequently, the insulating film pattern 11a and the insulating film 12 are removed, as shown in Fig. 37, and the semiconductor substrate body 2S is then subjected to a thermal treatment. However, the thermal treatment at this time is intended primarily to recover the damage due to the implantation of the ions of the well forming impurity. Hence, this thermal treatment is so deep that the well forming impurity will not substantially diffuse, namely, that the impurity will not appear in the surface portion of the semiconductor substrate body 2S.

Considering this, the treating conditions are as follows, although they cannot be generally specified because they are different depending upon the products or the like. That is: the treating temperature is exemplified by 900°C to 1,100°C; the treating time period is exemplified by 10 min. to 60 min.; and the treating atmosphere is preferably exemplified by one containing a small quantity of O₂ gases.

As described above, the semiconductor substrate body 2S is subjected to the thermal treatment before its principal plane is formed with the epitaxial layer. As a result, the crystal defect in the surface layer of the semiconductor substrate body 2S due to the ion implantation of the well forming impurity can be reduced to recover the damage so that the epitaxial layer of excellent crystallizability can be formed over the principal plane of the semiconductor substrate body 2S.

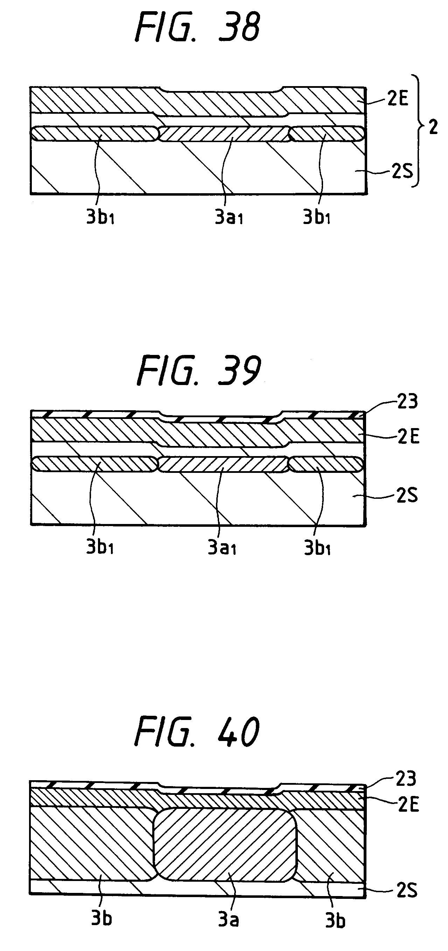

After this, the semiconductor substrate body 2S is subjected to the CVD treatment (or the epitaxial growth treatment) or the like at 800°C to 1,000°C by using the SiH₄ gases and the H₂ gases, for example, to form the epitaxial layer 2E of the non-doped single crystalline Si, for example, over the principal plane of the semiconductor substrate body 2S, as shown in Fig. 38. Thus, there is formed the semiconductor substrate 2 in which the epitaxial layer 2E is laminated over the semiconductor substrate body 2S.

This epitaxial layer 2E is given a thickness of about 0.3 µm to 3.0 µm and a specific resistance of about 200 to 500 Ωcm. It is sufficient that the impurity concentration of the epitaxial layer 2E is lower than that of the wells.

Next, the semiconductor substrate 2 thus formed is rinsed with an HF liquid or the like. After this, the semiconductor substrate 2 is subjected to a thermal oxidation treatment, for example, to form a capping insulating film 23 of SiO₂, for example, over the epitaxial layer 2E, as shown in Fig. 39.

However, the thermal oxidation at this time is done under such treating conditions that the well forming n-type, as introduced into the semiconductor substrate body 2S, will not diffuse. In this case, too, the treating conditions are as follows, although they cannot be generally specified because they are difference according to the design conditions. Specifically, the treating temperature is exemplified by 850°C to 950°C, and the treating time period is exemplified by about 20 min.

This capping insulating film 23 is one for preventing the impurities in the well forming doped regions 3a1 and 3b1 and so on from diffusing at the later-described well diffusion step from the semiconductor substrate 2 into the diffusion furnace to dope the epitaxial layer 2E (as called the "auto-doping phenomenon").

Thanks to the capping insulating film 23, it is possible to suppress the diffusion (as called the "out-diffusion phenomenon") of the impurities of the well forming doped regions 3a1 and 3b1 at the well diffusion step and to prevent the epitaxial layer 2E from being doped by the impurities having diffused. As a result, the impurity concentration setting accuracy of the epitaxial layer 2E can be improved to improve the setting accuracy of the resistivity or the like in the epitaxial layer 2E.

However, the method of forming the capping insulating film 23 should not be limited to the thermal oxidation but can be modified in various manners such as the low-pressure CVD method or the plasma CVD method. In these cases, the treating temperature can be lower than that of the case of the thermal oxidation. In case the low-pressure CVD method is used, for example, the treating temperature can be lowered to about 740°C, for example.

Subsequently, the semiconductor substrate 2 is subjected to the thermal diffusion to form the n-type well 3a and the p-type well 3b, as shown in Fig. 40. At this thermal diffusion, however, the well forming impurities are caused to diffuse into the epitaxial layer 2E such that the lightly doped epitaxial layer 2E having a thickness of about 0.3 µm is left in the surface layer.

Considering this, the treating conditions cannot be generally specified but as follows, although they are different depending upon the product designing conditions such as the thickness of the epitaxial layer, the depth of the well diffusion layer, the boundary of the adjoining well and the length to be left with the lightly-doped region. Specifically: the treating temperature is exemplified by 1,200°C; the treating time period is exemplified by about 1 hr. to 3 hrs.; and the treating atmosphere is preferably exemplified by an atmosphere of N₂ gases.

After this, the capping insulating film 23 is removed, and the semiconductor integrated circuit device is then manufactured at the steps similar to those of Fig. 7 and later of the foregoing embodiment 1.

Thus, according to the present embodiment 13, the following effects can be achieved in addition to those obtained by the foregoing embodiments 1 and so on.
(1) Prior to the step of forming the epitaxial layer 2E, the semiconductor substrate body 2S is subjected to the thermal treatment for recovering the damage of the semiconductor substrate body 2S due to the ion implantation of the well forming impurities. As a result, the crystal defect of the surface layer of the semiconductor substrate body 2S can be reduced to recover the damage so that the epitaxial layer 2E having excellent crystallizability can be formed.
(2) Prior to the well diffusion treating step, the capping insulating film 23 is formed over the epitaxial layer 2E so that the auto-diffusion phenomenon of the impurities at the diffusion treating step can be suppressed while preventing the auto-doping phenomenon. As a result, it is possible to improve the setting accuracy of the impurity concentration in the epitaxial layer 2E.
(3) Thanks to the aforementioned effect (2), the fluctuation of the electric characteristics (e.g., the resistivity) of the epitaxial layer 2E due to the auto-doping phenomenon can be prevented to improve the setting accuracy of the electric characteristics.
(4) Thanks to the aforementioned effects (1) to (3), it is possible to improve the performances, reliabilities and production yields of the MOS·FETs 5N and 5P (as shown in Fig. 1) to be formed in the epitaxial layer 2E.

### (Embodiment 14)

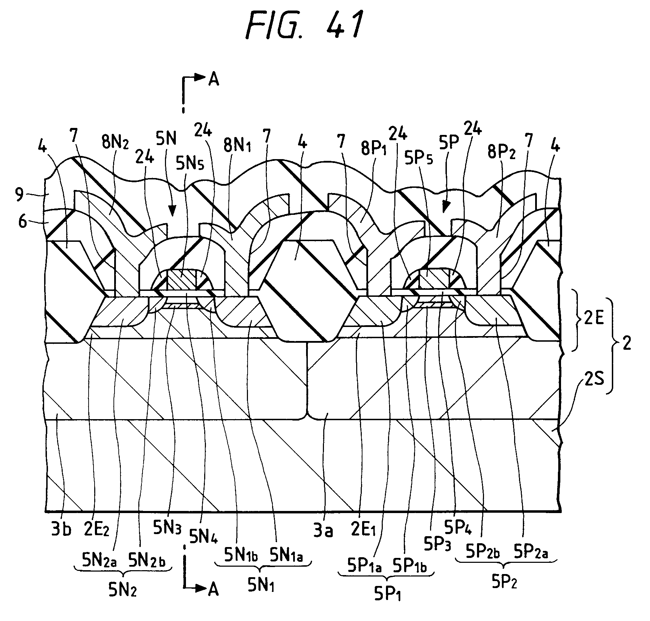

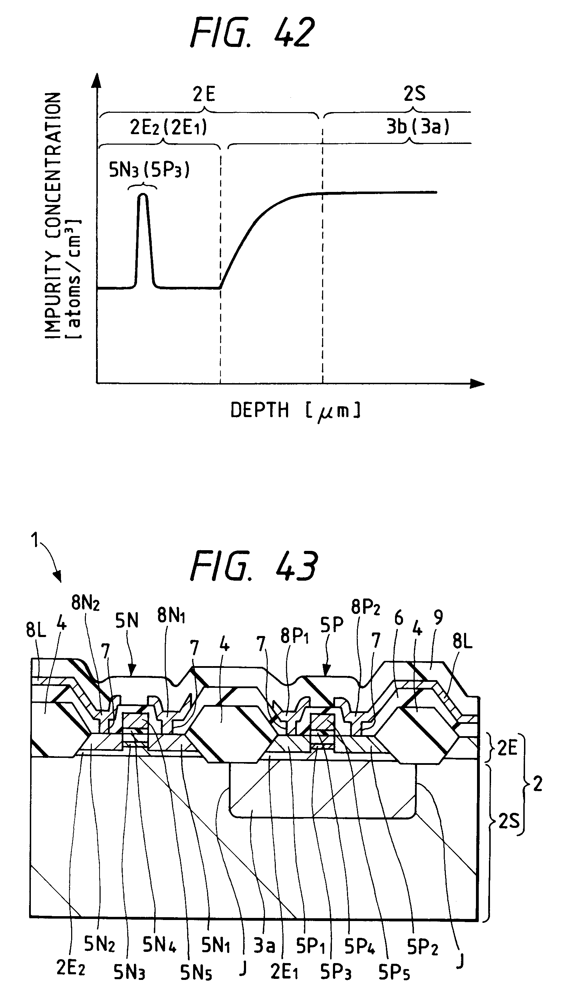

Fig. 41 is a section showing an essential portion of a semiconductor integrated circuit device according to a further embodiment of the present invention, and Fig. 42 is a graph diagram plotting a depthwise impurity concentration distribution of a semiconductor substrate in the semiconductor integrated circuit device of the present invention.

In the present embodiment 14, as shown in Fig. 41, on the epitaxial layer 2E of the semiconductor substrate, there are mounted the MOS·FETs 5N and 5P which have the LDD (Lightly Doped Drain) structure. In other words, the present embodiment 14 is different in the drain structures of the MOS·FETs 5N and 5P from the foregoing embodiment 1.

Specifically, the semiconductor regions 5N1 and 5N2 forming the source/drain regions of the MOS·FET 5N are composed of heavily doped regions 5N1a and 5N2a and lightly doped regions 5N1b and 5N2b formed at the side of the gate electrode 5N5 or the channel forming region. The semiconductor regions 5P1 and 5P2 forming the source/drain regions of the MOS·FET 5P are composed of heavily doped regions 5P1a and 5P2a and lightly doped regions 5P1b and 5P2b formed at the side of the gate electrode 5P5 or the channel forming region.

The semiconductor regions 5N1 and 5N2 of the MOS·FET 5N are formed in the lightly doped epitaxial layer 2E2. The semiconductor regions 5N1 and 5N2 of the MOS·FET 5N are formed in the lightly doped epitaxial layer 2E1.

Both the heavily doped regions 5N1a and 5N2a and the lightly doped regions 5N1b and 5N2b contain the n-type impurity of phosphor or As, for example. The lightly doped regions 5N1b and 5N2b have their impurity concentrations set lower than those of the heavily doped regions 5N1a and 5N2a.

Moreover, both the heavily doped regions 5P1a and 5P2a and the lightly doped regions 5P1b and 5P2b contain the p-type impurity of phosphor or As, for example. The lightly doped regions 5P1b and 5P2b have their impurity concentrations set lower than those of the heavily doped regions 5P1a and 5P2a.

Incidentally, the MOS·FETs 5N and 5P have their gate electrodes 5N5 and 5P5 formed on their sides with silicide walls 24 of SiO₂, for example, so as to make the LDD structure. The heavily doped regions 5N1a and 5N2a, and 5P1a and 5P2a are formed in self-alignment with the side walls 24. The lightly doped regions 5N1b and 5N2b are formed in self-alignment with the gate electrode 5N5. The lightly doped regions 5P1b and 5P2b are formed in self-alignment with the gate electrode 5P5.

In this case, too, the punch-through stoppers 5N3 and 5P3 have their maximum concentration portions located in positions shallower than those of the semiconductor regions 5N1 and 5N2 of the MOS·FET 5N and the semiconductor region 5P1 and 5P2 of the MOS·FET 5P. In the present embodiment 14, the punch-through stoppers 5N3 and 5P3 have their maximum concentration portions located in the vicinity of the depth of the lightly doped regions 5N1b and 5N2b of the semiconductor regions 5N1 and 5N2 and the lightly doped regions 5P1b an 5P2b of the semiconductor regions 5P1 and 5P2.

In short, the punch-through stoppers 5N3 and 5P3 are made so deep as to contact with the lightly doped regions 5N1b and 5N2b.

Here, a depthwise impurity concentration distribution of the semiconductor substrate 2, as taken along line A - A of Fig. 41, is plotted in Fig. 42. Incidentally, the impurity distribution of Fig. 42 can apply to the foregoing embodiments 1 to 13, too.

The epitaxial layer 2E2 (or 2E1) forming the surface layer of the epitaxial layer 2E is a lightly doped region. In their midway, however, there is formed a more heavily doped portion than the punch-through stoppers 5N3 and 5P3. Below the epitaxial layer 2E2 (or 2E1), there are formed the wells 3a and 3b as a heavily doped region.

Thus, the heavily doped regions 5N1a and 5N2a of the MOS·FET 5N are so formed in the epitaxial layer 2E1 as to contact with the epitaxial layer 2E2 so that the drain junction capacity can be reduced.

Thus, the present embodiment 14 can achieve effects similar to those of the foregoing embodiment 1.

Although our invention has been specifically described in connection with its embodiments, it should not be limited to the foregoing embodiments 1 to 14 but can naturally be modified in various manners within the scope of the invention.

For example, the foregoing embodiments 1 to 14 have been described as to the case in which the present invention is applied to the semiconductor integrated circuit device having the so-called "double well structure." Despite of this description, however, the present invention should not be limited thereto but can be applied to a semiconductor integrated circuit device of the so-called "single well structure" having one well, as shown in Fig. 43.

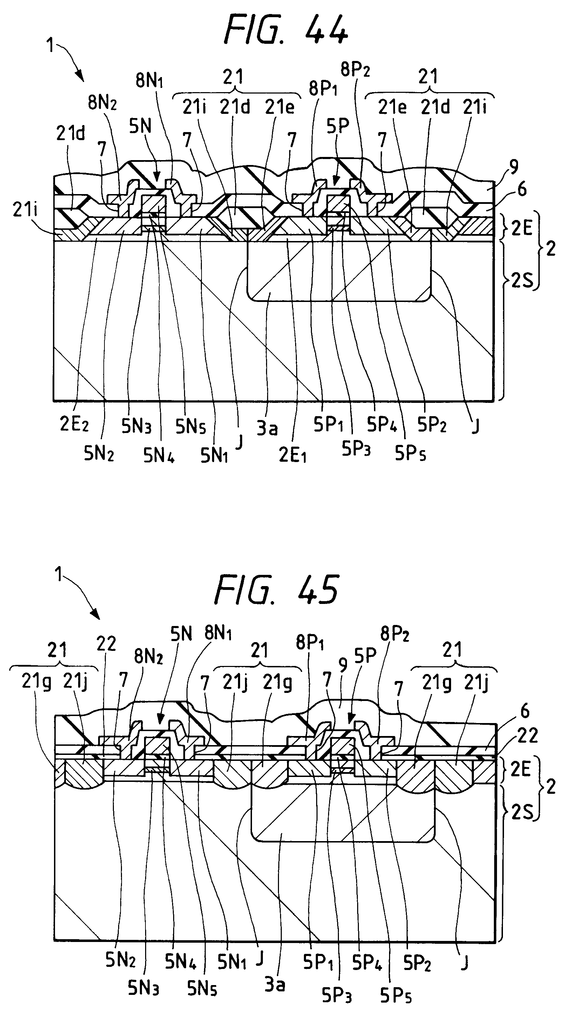

On the other hand, Fig. 44 shows a modification of the element isolating portion 21 in the case of the semiconductor integrated circuit device having the single well structure. The element isolating portion 21 is composed of the field insulating film 21d and the two semiconductor regions 21e and 21i of different conduction types formed below the field insulating film 21d and adjacent to each other. The semiconductor region (or fourth region) 21i over the semiconductor substrate body 2S is doped with the impurity of the same conduction type as that of the impurity contained in the semiconductor substrate body 2S, such as the p-type impurity of boron. The remaining construction is identical to that of the foregoing embodiment 9.

On the other hand, Fig. 45 shows another modification of the element isolating portion 21 in the case of the semiconductor integrated circuit device having the single well structure. The element isolating portion 21 is composed of two semiconductor regions 21g and 21j of different conduction types arranged adjacent to each other. The semiconductor region (or sixth region) 21j over the semiconductor substrate body 2S is doped with the impurity of the same conduction type as that of the impurity contained in the semiconductor substrate body 2S, such as the p-type impurity of boron. The remaining construction is identical to that of the foregoing embodiment 10.

On the other hand, the foregoing embodiments 1 to 14 have been described as to the case in which the epitaxial layer forming the pMOS and the nMOS has its impurity concentration set by the ion implantation method separately of another manufacture step. Despite of this description, however, the impurity concentration of the epitaxial layer may be set according to the desired element characteristics at an ion implantation step for forming the punch-through stopper, for example.

At the time of forming the punch-through stopper, for example, the impurity concentration of the layer below the punch-through stopper may be set to a predetermined value. At this ion implantation step for forming the punch-through stopper, moreover, the impurity concentration of the layer below the punch-through stopper is set to a predetermined value, and the impurity concentration of the channel over the punch-through stopper may be set according to the desired element characteristics.

On the other hand, the foregoing embodiments 1 to 14 have been described as to the case in which the SiH₄ gases are used at the time of the epitaxial growth. Despite of this description, however, the present invention should not be limited thereto but can be modified in various manners. For example, dichlorosilane (SiH₂Cℓ₂) having a less auto-doping may be used.

On the other hand, the foregoing embodiment 1 has been described as to the case in which the structure of the present invention is applied to the analog circuit. Despite of this description, however, the present invention should not be limited thereto but can also be applied to a digital circuit, for example.

Moreover, this digital circuit can be exemplified by a gate circuit, an adder, a timer, a counter, a shift register and a pass-transistor gate circuit.

On the other hand, the foregoing embodiment 1 has been described as to the case in which the structure of the present invention is applied to the differential amplifier. Despite of this description, however, the present invention should not be limited thereto but can also find various applications such as an AD/DA converter, a comparator, a modulator or a sense amplifier of a memory.

On the other hand, the foregoing embodiments 1 to 14 have been described as to the semiconductor integrated circuit device having the elements. Despite of this description, however, the present invention should not be limited thereto but can also find various applications including active elements such as bipolar transistors or diodes, capacitors having pn junctions and insulating films between electrodes, or passive elements such as diffusion resistors. The present invention can be further applied to microprocessors, ASIC (Application Specific IC) or various semiconductor memory integrated circuits having those elements integrated therein.

On the other hand, the foregoing embodiments 1 to 14 have been described as to the case using the p-type semiconductor substrate body. Despite of this description, however, the present invention should not be limited thereto but can also find an application using an n-type semiconductor substrate body.

On the other hand, the foregoing embodiments 1 to 14 have been described as to the MOS·FETs. Despite of this description, however, the present invention should not be limited thereto but can also use MIS (Metal Insulator Semiconductor) FETs.

On the other hand, the foregoing embodiment 7 has been described as to the case in which the epitaxial layer in the memory cell array has its impurity concentration set equal to or higher than that of the wells. Despite of this description, however, the present invention should not be limited thereto but can also modified, as in the foregoing embodiment 6 and so on, such that even the epitaxial layer in the memory cell array has its impurity concentration set, below and near the semiconductor region to be connected with the data lines, as low as that of the epitaxial layer. Moreover, the punch-through stopper may be formed in the regions having a lower impurity concentration.

On the other hand, the foregoing embodiment 7 has been described as to the case in which the present structure is applied to the semiconductor integrated circuit device having the EEPROM. Despite of this description, however, the present invention should not be limited thereto but can also find various applications such as another ROM such as EPROM (Erasable Programmable ROM (Read Only Memory)) or mask ROM.

On the other hand, the present structure can also be applied to the so-called "ferroelectric memory circuit (FRAM: Ferroelectric Random Access Memory)", i.e., a memory circuit having a capacitor in which a capacity insulating film made of a ferroelectric material such as PZT (PbZrTiO₃) is sandwiched between upper and lower electrodes.

On the other hand, the foregoing embodiment 7 has been described as to the case in which the epitaxial layer in the memory cell has its impurity concentration set equal to or higher than that of the wells. Despite of this description, however, the present invention should not be limited thereto but can also be modified such that the impurity concentration of the epitaxial layer of the memory cell is as low as that of the epitaxial layer of the foregoing embodiment 1. This modification can achieve the effects (1) to (11) and (16) to (24) of the foregoing embodiment 1.

Although the foregoing description has been directed mainly to the case in which our invention is applied to the semiconductor integrated circuit device having the MOS·FETs providing the background thereof. Despite of this description, however, the present invention can also find various applications such as another semiconductor integrated circuit device having a BiCMOS (Bipolar CMOS) in which bipolar transistors and MOS·FETs are mounted on a common semiconductor substrate.

The effects to be achieved by a representative one of the invention, as disclosed herein, will be briefly described in the following:
(1) According to the semiconductor integrated circuit device of the present invention, the lightly doped epitaxial layer, as formed over the heavily doped first and second regions, is formed with the predetermined elements. As a result, the elements can have their characteristics set accurately without being influenced by the impurities in the first region, the second region and the semiconductor substrate body so that the setting accuracy of the element characteristics can be improved. Thus, it is possible to improve the performance, reliability and production yield of the semiconductor integrated circuit device.
(2) According to the semiconductor integrated circuit device of the present invention, the predetermined elements are formed in the lightly doped epitaxial layer so that the junction capacity of the semiconductor regions forming the predetermined elements can be reduced. Thus, it is possible to improve the action speed of the semiconductor integrated circuit device.
(3) According to the semiconductor integrated circuit device of the present invention, the lightly doped epitaxial layer, as formed over the heavily doped first and second regions, is formed with the predetermined elements. As a result, the first region and the second region can have their impurity concentrations set substantially independently of the characteristics of the predetermined elements.
(4) Thanks to the aforementioned effect (3), it is possible to improve the latch-up breakdown voltage. Thus, it is possible to improve the performance, reliability and production yield of the semiconductor integrated circuit device.
(5) Thanks to the aforementioned effect (3), it is possible to improve the soft-error breakdown voltage. Thus, it is possible to improve the performance, reliability and production yield of the semiconductor integrated circuit device.
(6) Thanks to the aforementioned effect (3), the impurity concentrations of the first region and the second region can be set to values sufficient for the element isolations so that the channel stopper can be eliminated by extending the element isolating portion to the first region and the second region. Thus, the parasitic capacity can be reduced to improve the action speed of the semiconductor integrated circuit device.
(7) Thanks to the aforementioned effect (3), the punch-through breakdown voltage in the semiconductor substrate body can be improved to reduce the thicknesses of the first region and the second region. Thus, it is possible to reduce the thermal treating time period drastically for forming the first region and the second region.
(8) According to the semiconductor integrated circuit device of the present invention, the lightly doped epitaxial layer, as formed over the heavily doped first and second regions, is formed with the predetermined elements. As a result, the first region and the second region can have their impurity concentrations set substantially independently of the characteristics of the predetermined elements. Thus, it is possible to facilitate the control of forming the first region and the second region.
(9) According to the semiconductor integrated circuit device of the present invention, the element isolating portion is formed into the channel shape. As a result, even if the epitaxial layer is considerably thick, the element isolating portion capable of isolating the epitaxial layer individually for the element forming regions can be formed without increasing the area occupied by the element isolating portion. In other words, the semiconductor integrated circuit device can cope with the structure having a thick epitaxial layer.
(10) According to the semiconductor integrated circuit device of the present invention, the insulating film is formed by the thermal oxidation method on the surface of the channel for the element isolating portion. As a result, it is possible to satisfactorily protect the epitaxial layer in the channel, the semiconductor substrate body, and the junction portion of the first and second region. Thus, it is possible to improve the performance, reliability and production yield of the semiconductor integrated circuit device.
(11) According to the semiconductor integrated circuit device of the present invention, the epitaxial layer, as equipped with the MIS·FETs, is formed at a predetermined depth with the eighth region for the punch-through stopper. As a result, it is possible to prevent the punch-through phenomenon between the sources and drains of the MIS·FETs. Thus, it is possible to improve the performance, reliability and production yield of the semiconductor integrated circuit device.
(12) According to the semiconductor integrated circuit device of the present invention, the epitaxial layer in the element forming region for the electrostatic protection circuit attached to the input circuit and the power supply has its impurity concentration set equal to or higher than that of the first region. As a result, it is possible to eliminate the deviation of the minority carriers of the base region at the operating time of the bipolar transistors for the electrostatic protection circuit and to prevent any local current concentration in that epitaxial layer. As a result, the current can be uniformly established in the collector/base junctions of the bipolar transistors thereby to prevent the reduction of the electrostatic breakdown voltage of the electrostatic protection circuit. Thus, it is possible to improve the performance, reliability and production yield of the semiconductor integrated circuit device.
(13) According to the semiconductor integrated circuit device of the present invention, of the epitaxial layer, the epitaxial layer in the region forming the memory cells has its impurity concentration set to a value higher than that of the epitaxial layer in the element forming region for the internal circuit. As a result, it is possible to increase the junction capacity of the epitaxial layer and to form the barrier layer for preventing the carriers, which are produced due to the electron-hole pairs by the alpha ray, from invading the information holding portion. As a result, it is possible to prevent the drop of the memory holding characteristics of the semiconductor integrated circuit device having the memory cells. Thus, it is possible to improve the performance, reliability and production yield of the semiconductor integrated circuit device.
(14) According to the semiconductor integrated circuit device of the present invention, of the epitaxial layer, the epitaxial layer in the memory cell forming region has its impurity concentration set, only below the semiconductor region other than that to be connected with the data lines, to a value higher than that of the epitaxial layer in the element forming region for the internal circuit. As a result, It is possible to prevent the drop of the memory holding characteristics without increasing the load capacity of the data line. Thus, it is possible to improve the performance, reliability and production yield of the semiconductor integrated circuit device.
(15) According to the semiconductor integrated circuit device of the present invention, the thermal treatment is done for recovering the damage after the impurity introducing step, followed by forming the epitaxial layer, so that the crystal defect of the semiconductor substrate body surface layer can be reduced to recover the damage. As a result, it is possible to form the epitaxial layer having an excellent crystallizability. Thus, it is possible to improve the performance, reliability and production yield of the semiconductor integrated circuit device.
(16) According to the semiconductor integrated circuit device of the present invention, prior to the thermal diffusion treating step for forming the first region and the second region, the cap film is formed over the epitaxial layer so that the first impurity and the second impurity can be suppressed from diffusing into the diffusion furnace during the diffusion treating step while preventing the epitaxial layer from being doped with the impurities having diffused. Thus, it is possible to improve the accuracy of setting the impurity concentration in the epitaxial layer.
(17) Thanks to the aforementioned effect (16), the electric characteristics such as the resistivity in the epitaxial layer can be prevented from fluctuating to improve their setting accuracy. Thus, it is possible to improve the performance, reliability and production yield of the semiconductor integrated circuit device.

## Claims

1. A semiconductor integrated circuit device comprising:
a first semiconductor region (3a; 3b) formed over a semiconductor substrate body (2S);
an epitaxial layer (2E) formed over said semiconductor substrate body and said first semiconductor region;
an element isolating insulating film (4, 21) formed in said epitaxial layer and extending to said first semiconductor region;
a gate insulating film (5N4, 5P4) of a MIS.FET formed over said epitaxial layer;
a gate electrode (5N5, 5P5) of said MIS.FET formed over said gate insulating film;
a pair of second semiconductor regions (5N1, 5N2; 5P1, 5P2) formed in said epitaxial layer to construct the source/drain regions of said MIS.FET,
wherein said epitaxial layer has a thickness larger than the depth of said second semiconductor regions, and
wherein said epitaxial layer has an impurity concentration lower than that of said first semiconductor region; and
a third semiconductor region (5N3, 5P3) formed at a position of a predetermined depth in said epitaxial layer to have a conduction type opposite to that of said second semiconductor regions and an impurity concentration higher than that of said epitaxial layer,
wherein said third semiconductor region is so formed at a position shallower than said second semiconductor regions as to contact with said second semiconductor regions.

2. A semiconductor integrated circuit device according to claim 1,
wherein said second semiconductor regions include heavily doped regions (5N1a, 5N2a, 5P1a, 5P2a) and lightly doped regions (5N1b, 5N2b, 5P1b, 5P2b) arranged inside of said heavily doped regions, to construct the LDD structure.

3. A semiconductor integrated circuit device according to claim 2,
wherein said third semiconductor region has its maximum concentration portion at a position shallower than the paired second semiconductor regions in said MIS.FET.

4. A semiconductor integrated circuit device according to claim 1, further comprising:
a fourth semiconductor region (3b; 3a) containing a first impurity of a predetermined conduction type for forming a PN junction (J); and
an epitaxial layer (2E) formed over said semiconductor substrate body and containing an impurity in a lower concentration than that of said fourth semiconductor region,
wherein said first semiconductor region (3a;3b) contains an impurity of the same conduction type as that of said second impurity and is form adjacent to said fourth semiconductor region, and
wherein said element isolating insulating film (4, 21) is formed to reach said fourth semiconductor region such that said PN junction terminates at the bottom portion of said element isolating insulating film.

5. A semiconductor integrated circuit device according to claim 4,
wherein said element isolating insulating film (21) is formed in a channel extending to the upper portion of said semiconductor substrate body (2S).

6. A semiconductor integrated circuit device according to claim 5,
wherein said element isolating insulating film (21) includes an insulating film (21b) formed on a surface of said channel by a thermal oxidation method.

7. A semiconductor integrated circuit device according to claim 4,
wherein, of said epitaxial layer (2E), the epitaxial layer (15a1, 15b1) in an element forming region (B) for an electrostatic protection circuit to be attached to an input circuit constituting a semiconductor integrated circuit and a power circuit has its impurity concentration set equal to or higher than that of said first semiconductor region (3a; 3b).

8. A semiconductor integrated circuit device according to claim 4,
wherein an analogue circuit is constructed.

9. A semiconductor integrated circuit device according to claim 4,
wherein, of said epitaxial layer (2E), the epitaxial layer (2E5, 2E6) in a memory cell forming region (M) has its impurity concentration set higher than that of the epitaxial layer (2E1, 2E2) in an element forming region (a) for an internal circuit.

10. A semiconductor integrated circuit device according to claim 4,
wherein, of said epitaxial layer (2E), the epitaxial layer (2E5, 2E6) in a memory cell forming region (M) has its impurity concentration set, below the semiconductor region other than that to be connected with a data line (8DL), to a value higher than that of the epitaxial layer (2E1, 2E2) in the element forming region (A) for an internal circuit.

11. A semiconductor integrated circuit device according to claim 9,
wherein said memory cell is a memory cell of a dynamic random access memory, a memory cell of a static random access memory or a memory cell of a read only memory.

12. A semiconductor integrated circuit device according to claim 4,
wherein said epitaxial layer (2E) is equipped with memory cells (MC) of a dynamic random access memory, and
wherein the epitaxial layer (2E5,2E6) below the semiconductor region for the source/drain connected between a transfer MOS-FET (16) and a capacitor (17), as construct said memory cells, has its impurity concentration set to a value higher than that of the epitaxial layer below the semiconductor region for the source/drain, as connected between said transfer MOS.FET (16) and the data line (8DL).

13. A semiconductor integrated circuit device according to claim 4,
wherein said epitaxial layer (2E) is equipped with memory cells of a static random access memory, and
wherein the epitaxial layer (2E5) below the semiconductor region for the source/drain connected between a transfer MOS.FET (18) and a driver MOS.FET (19), as construct said memory cells, has its impurity concentration set to a value higher than that of the epitaxial layer (2E6) below the semiconductor region for the source/drain, as connected between said transfer MOS.FET (18) and the data line (8DL).

14. A process for manufacturing a semiconductor integrated circuit device, comprising:
(a) the step of doping a semiconductor substrate body (2S) with a first impurity;
(b) the step of doping said semiconductor substrate body with a second impurity of a conduction type opposite to that of said first impurity;
(c) the step of forming an epitaxial layer (2E) over the principal plane of the semiconductor substrate body which has been doped with said first impurity and said second impurity;
(d) the step of forming a cap film over said epitaxial layer; and
(e) the step of forming a first semiconductor region (3a) and a second semiconductor region (3b) individually by subjecting the semiconductor substrate body formed with said epitaxial layer, to a thermal diffusion treatment to diffuse said first impurity and said second impurity.

15. A process for manufacturing a semiconductor integrated circuit device according to claim 14, further comprising:
the step of subjecting said semiconductor substrate body to a thermal treatment for recovering from the damage after the steps of introducing said first impurity and said second impurity and before the step of forming said epitaxial layer.

16. A process for manufacturing a semiconductor integrated circuit device according to claim 15,
wherein said thermal treatment has a temperature of 900°C to 1,100°C.

17. A process for manufacturing a semiconductor integrated circuit device according to claim 14,
wherein a lightly doped region having no impurity diffusion is left by at least 0.3µm from the principal plane of said epitaxial layer (2E) at said thermal diffusion step and when said first impurity and said second impurity are to be diffused into said epitaxial layer.

18. A process for manufacturing a semiconductor integrated circuit device according to claim 14, further comprising, before elements are to be formed in said epitaxial layer:
(f) the step of doping such portion (2E1) of said epitaxial layer as overlies said first semiconductor region (3a), with an impurity of the same conduction type as that of said first impurity in a concentration lower than that of said first impurity region; and
(g) the step of doping the epitaxial layer (2E2) other than that over said first semiconductor region (3a) with an impurity of the same conduction as that of said second impurity in a concentration lower than that of said second semiconductor region (36).

19. A process for manufacturing a semiconductor integrated circuit device according to claim 14, further comprising, before elements are to be formed in said epitaxial layer (2E):
(h) the step of setting to a predetermined value the impurity concentration of the epitaxial layer portion below a third semiconductor region for a punch-through stopper (5N3, 5P3), which is doped with an impurity having the same conduction type as the impurity of said epitaxial layer and a higher impurity concentration than that of the same impurity, when said third semiconductor region for the punch-through stopper is to be formed at a predetermined depth position in said epitaxial layer.

20. A process for manufacturing a semiconductor integrated circuit device according to claim 14, further comprising, before elements are to be formed in said epitaxial layer (2E):
(i) the step of setting to a predetermined value the impurity concentration of the epitaxial layer portion below and over a third semiconductor region for a punch-through stopper (5N3, 5P3), which is doped with an impurity having the same conduction type as the impurity of said epitaxial layer and a higher impurity concentration than that of the same impurity, when said third semiconductor region for the punch-through stopper is to be formed at a predetermined depth position in said epitaxial layer.

21. A process for manufacturing a semiconductor integrated circuit device according to claim 14,
wherein said first impurity is an n-type impurity of phosphor whereas said second impurity is a p-type impurity of boron.

22. A semiconductor integrated circuit device according to claim 4,
wherein said epitaxial layer has a thickness of 0.3 µm to 3 µm.

23. A semiconductor integrated circuit device according to claim 1,
wherein said epitaxial layer has a thickness of 0.3 µm to 3 µm.

24. A semiconductor integrated circuit device according to claim 1 or 4,
wherein said gate insulating film (5N4, 5P4)) has an oxide film formed by thermally oxidising the principal plane of said epitaxial layer (2E).

25. A process for manufacturing a semiconductor integrated circuit device according to claim 17 or 20, further comprising:
(j) the step of forming an oxide film (5N4, 5P4) over the principal plane of said epitaxial layer after said step (e),
wherein said oxide film forms the gate insulating film of a MIS.FET.

26. A process for manufacturing a semiconductor integrated circuit device according to claim 18, further comprising:
(k) the step of forming an oxide film (5N4, 5P4) over the principal plane of said epitaxial layer after said steps (f) and (g),
wherein said oxide film forms the gate insulating film of a MIS.FET.
